(19) Europäisches Patentamt
European Patent Office
Office européen des brevets

(11) **EP 1 356 595 B1**

(12) **FASCICULE DE BREVET EUROPEEN**

(45) Date de publication et mention
de la délivrance du brevet:
**09.08.2006 Bulletin 2006/32**

(51) Int Cl.:
***H03M 7/30*** (2006.01)

(21) Numéro de dépôt: **02701380.4**

(22) Date de dépôt: **01.02.2002**

(86) Numéro de dépôt international:
**PCT/FR2002/000394**

(87) Numéro de publication internationale:
**WO 2002/063776 (15.08.2002 Gazette 2002/33)**

(54) **PROCEDE DE COMPRESSION/DECOMPRESSION D'UN DOCUMENT STRUCTURE**

VERFAHREN ZUR KOMPRESSION UND DEKOMPRESSION EINES STRUKTURIERTEN
DOKUMENTS

METHOD FOR COMPRESSING/DECOMPRESSING A STRUCTURED DOCUMENT

(84) Etats contractants désignés:
**AT BE CH CY DE DK ES FI FR GB GR IE IT LI LU
MC NL PT SE TR**

(30) Priorité: **02.02.2001 FR 0101447**

(43) Date de publication de la demande:
**29.10.2003 Bulletin 2003/44**

(73) Titulaire: **Expway
51100 Reims (FR)**

(72) Inventeurs:
• **SEYRAT, Claude
F-75001 Paris (FR)**
• **THIENOT, Cédric
F-75011 Paris (FR)**

(74) Mandataire: **de Roquemaurel, Bruno et al
Novagraaf Technologies
122, rue Edouard Vaillant
92593 Levallois Perret Cedex (FR)**

(56) Documents cités:
**EP-A- 0 928 070**     **WO-A-00/70770**

• **LIEFKE H ET AL: "XMILL: AN EFFICIENT
COMPRESSOR FOR XML DATA" SIGMOD
RECORD, ASSOCIATION FOR COMPUTING
MACHINERY, NEW YORK, US, vol. 29, no. 2, juin
2000 (2000-06), pages 153-164, XP001002286**
• **GIRARDOT M ET AL: "MILLAU: AN ENCODING
FORMAT FOR EFFICIENT REPRESENTATION
AND EXCHANGE OF XML OVER THE WEB"
COMPUTER NETWORKS AND ISDN SYSTEMS,
NORTH HOLLAND PUBLISHING. AMSTERDAM,
NL, vol. 33, no. 1-6, juin 2000 (2000-06), pages
747-765, XP001005949 ISSN: 0169-7552**
• **WIRELESS APPLICATION PROTOCOL FORUM:
"WAP Binary XML Content Format" WAP BINARY
XML CONTENT FORMAT DOCUMENT ID WAP-
192-WBXML-20000515 VERSION 1.3, XX, XX, 15
mai 2000 (2000-05-15), pages 1-25, XP002168490**
• **NACK F ET AL: "EVERYTHING YOU WANTED TO
KNOW ABOUT MPEG-7: PART 2" IEEE
MULTIMEDIA, IEEE COMPUTER SOCIETY, US,
vol. 6, no. 4, octobre 1999 (1999-10), pages 64-73,
XP000880605 ISSN: 1070-986X**

**EP 1 356 595 B1**

**Description**

La présente invention concerne un procédé de compression / décompression de documents structurés.

Elle s'applique notamment, mais non exclusivement, à la transmission de documents tels que des images ou séquences d'images, des données vidéo ou sonores, par des réseaux de transmission de données numériques, ainsi qu'au stockage de tels documents, et de données décrivant ces documents.

Un document structuré est une collection d'éléments d'informations associés chacun à un type et des attributs, et composés entre eux selon des relations principalement hiérarchiques. Ces documents emploient un langage de structuration tel que SGML, HTML, XML, permettant notamment de distinguer les différents sous-éléments d'informations composant le document. Par opposition, dans un document dit linéaire, les informations de contenu du document sont mélangées aux informations de présentation et de typage.

Un document structuré inclut des repères de séparation des différents éléments d'informations du document. Dans le cas des formats SGML, XML ou HTML, ces repères appelés "balises" sont de la forme "<XXXX>" et "</XXXX>", le premier repère indiquant le début d'un élément d'informations "XXXX" et le second la fin de cet élément. Un élément d'informations peut être composé de plusieurs éléments d'informations de plus bas niveau. Ainsi, un document structuré présente un schéma de structure hiérarchique ou arborescente, chaque noeud représentant un élément d'informations et étant relié à un noeud de niveau hiérarchique supérieur représentant un élément d'informations qui contient les éléments d'informations de niveau inférieur. Les noeuds situés en bout de branche de cette structure arborescente représentent des éléments d'informations contenant des données d'un type prédéfini, qui ne peuvent pas être décomposées en sous-éléments d'informations.

Ainsi, un document structuré contient des repères de séparation représentés sous la forme de données textuelles ou binaires, ces repères délimitant des éléments ou sous-éléments d'informations pouvant eux-mêmes contenir d'autres sous-éléments d'informations délimités par des repères.

Par ailleurs, un document structuré est associé à ce qu'on appelle un schéma de structure définissant sous la forme de règles la structure et le type d'information de chaque élément d'informations du document. Un schéma est constitué de groupes imbriqués de composants, ces groupes pouvant être des séquences ordonnées, des groupes de composants alternatifs ou des groupes de composants nécessaires, ordonnés ou non ordonnés.

A l'heure actuelle, il existe plusieurs algorithmes de compression de document numérique. Certains algorithmes de compression sont conçus pour traiter directement les données binaires du document, sans tenir compte du type de ces données. Ces algorithmes présentent l'avantage de pouvoir traiter n'importe quel document, mais sont peu performants (taux de compression peu élevé) pour traiter des documents volumineux qui sont généralement de type son ou image.

On connaît par ailleurs d'autres algorithmes de compression plus efficaces, mais spécialement adaptés à un type de données, par exemple de type image ou son, de sorte qu'ils ne sont pas utilisables, ou performants s'ils sont appliqués à des documents ne contenant pas exclusivement des données pour lesquelles ils sont conçus. Par conséquent les algorithmes de compression spécifiques d'un type de données particulier sont peu efficaces et mal adaptés pour traiter les documents structurés contenant différents types de données.

Dans les documents "XMILL: An efficient Compressor for XML Data" de H. Liefke et al., Sigmod Record, Association for Computing Machinery, New York, US, Vol. 29, n°2, juin 2000, pages 153-164, et "Millau: An Encoding Format for Efficient Representation and Exchange of XML over the Web" de M. Girardot et al., Computer Networks ans ISDN Systems, North Holland Publishing. Amsterdam, NL, Vol. 33, n° 1-6, juin 2000, pages 747-765, on a mis au point des algorithmes de compression adaptés à la compression de documents au format XML.

La présente invention a pour but de supprimer les inconvénients mentionnés ci-avant et d'améliorer les algorithmes adaptés aux documents au format XML. Cet objectif est atteint par la prévision d'un procédé de compression d'un document structuré comprenant des éléments d'informations imbriqués les uns dans les autres et associés chacun à un type d'information, le document structuré étant associé à au moins un schéma de structure définissant une structure arborescente du document et comprenant des composants de structure imbriqués les uns dans les autres, chaque type d'information du document étant défini par un composant du schéma.

Selon l'invention ce procédé comprend des étapes consistant à :

- analyser le schéma de structure du document, générer, pour chaque composant du schéma de structure, une séquence d'instructions exécutables, comportant des instructions d'insertion dans un flux binaire, de codes de contrôle et de valeurs compressées d'éléments d'informations ou de codes d'appel de séquences d'instructions de composant, et des instructions de contrôle du déroulement de l'exécution de la séquence en fonction des valeurs des codes de contrôle,
  l'exécution des séquences d'instructions sur le document structuré permettant de compresser le document structuré en un flux binaire contenant les valeurs compressées des éléments d'informations du document,

- exécuter sur le document structuré les séquences d'instructions générées, pour obtenir un flux binaire contenant les valeurs compressées des éléments d'informations du document.

Selon une particularité de l'invention, le document comprenant des éléments de base non décomposés en sous-éléments, au moins un type d'information des éléments de base est associé au préalable à un algorithme de compression adapté au type d'information, le procédé comprenant, durant l'exécution des séquences d'instructions, l'application de l'algorithme de compression à la valeur de chaque élément d'information ayant un type d'information associé audit algorithme.

Selon une autre particularité de l'invention, le procédé comprend une étape de compilation des séquences d'instructions obtenues pour chaque composant dudit schéma de structure, pour obtenir un programme binaire de codage dédié audit schéma de structure, et directement exécutable ou interprétable par un calculateur pour compresser un document ayant le schéma de structure.

Selon encore une autre particularité de l'invention, le procédé comprend une étape préalable de normalisation du schéma de structure du document, de manière à obtenir un ordre unique prédéfini des composants du schéma.

Selon encore une autre particularité de l'invention, le procédé comprend une étape préalable d'optimisation et de simplification du schéma de structure du document consistant à réduire le nombre de niveaux d'imbrications de composants de structure.

Avantageusement, au moins un élément d'informations du document est associé, dans le flux binaire généré, à un code d'élément d'informations qui est repéré de manière à permettre l'accès direct à un élément d'infunnations compressé particulier dans le flux binaire, sans qu'il soit nécessaire de décompresser les éléments d'informations précédant l'élément à décompresser dans le flux binaire.

Selon encore une autre particularité de l'invention, le document compressé généré comprend pour chaque élément d'informations du document structuré, un code permettant de déterminer le type d'information associé à l'élément d'informations, et la valeur binaire de l'élément d'informations.

Selon encore une autre particularité de l'invention, le schéma de structure du document comprend la définition de sous-types d'au moins un type d'information, et en ce que la séquence d'instructions qui est générée pour un composant d'un type ayant n sous-types comprend successivement :

- une instruction d'insertion d'un code de sous-type représentant un sous-type à appliquer à un élément correspondant dans le document au composant, associée à la taille de ce code en nombre de bits, et
- des instructions de test de la valeur du code de sous-type, chaque instruction de test étant associée à une référence au sous-type de l'élément correspondant à la valeur du code de sous-type testée, et à une séquence d'instructions qui est générée pour la compression d'un élément associé au sous-type.

De préférence, le flux binaire qui est généré pour un composant correspondant dans le document à plusieurs occurrences d'un ensemble d'éléments comportant au moins un élément d'informations, comprend un code de fin prédéfini.

Selon encore une autre particularité de l'invention, chaque composant du schéma de structure correspond dans le document à un ensemble d'éléments comprenant au moins un élément d'informations, et est en outre associé à un ensemble de nombres d'occurrences possibles, indiquant le nombre de fois qu'un ensemble d'éléments correspondant à ce composant, peut apparaître dans un élément d'informations de niveau immédiatement supérieur auquel il appartient.

Selon encore une autre particularité de l'invention, la séquence d'instructions qui est générée pour un composant ayant un nombre d'occurrences égal à 0 ou 1 comprend successivement :

- une instruction d'insertion d'un code de présence sur un bit indiquant la présence ou non dans le document d'un ensemble d'éléments correspondant au composant,
- une instruction de test de la valeur du code de présence, et
- en association avec l'instruction de test, si la valeur du code de présence indique la présence de l'ensemble d'éléments dans le document, une séquence d'instructions qui est générée pour le composant, indépendamment du nombre d'occurrences associé.

Selon encore une autre particularité de l'invention, la séquence d'instructions qui est générée pour un composant ayant un nombre d'occurrences compris entre n· et m comprend successivement :

- une instruction d'insertion d'un code de nombre d'occurrences indiquant le nombre d'occurrences successives d'un ensemble d'éléments correspondant au composant dans le document compressé, auquel on a retranché le nombre n minimum d'occurrences, associée à la taille de ce code en nombre de bits,

- une instruction de boucle définissant un nombre d'itérations correspondant à la valeur du code de nombre d'occurrences, et
- en association avec l'instruction de boucle, une séquence d'instructions qui est générée pour le composant, indépendamment du nombre d'occurrences associé.

Selon encore une autre particularité de l'invention, la séquence d'instructions qui est générée pour un composant ayant un nombre d'occurrences compris entre 0 et m comprend en outre :

- une instruction d'insertion d'un code de présence indiquant sur un bit la présence ou non dans le document d'au moins une occurrence de l'ensemble d'éléments correspondant au composant, et
- une instruction de test de la valeur du code de présence, associée à la séquence d'instructions générée pour un nombre d'occurrences compris entre 1 et m du composant, si la valeur du code de présence indique la présence d'au moins un ensemble d'éléments.

Selon encore une autre particularité de l'invention, la séquence d'instructions qui est générée pour un composant ayant un nombre d'occurrences compris entre n et m comprend successivement :

- une instruction d'insertion d'un code de présence sur un bit d'une occurrence d'un ensemble d'éléments correspondant au composant dans le document, associée à la taille de ce code en nombre de bits,
- une instruction de boucle à exécuter tant que le code de présence à insérer indique la présence d'une nouvelle occurrence de l'ensemble d'éléments,
- en association avec l'instruction de boucle, une séquence d'instructions qui est générée pour le composant, et une instruction d'insertion d'un nouveau code de présence sur un bit d'une nouvelle occurrence de l'ensemble d'éléments dans le document.

Selon encore une autre particularité de l'invention, chaque composant du schéma de structure correspond à un ensemble d'éléments comprenant au moins un élément d'informations, en ce que le schéma de structure du document structuré comprend au moins un composant de type séquence de composants ordonnés, dont l'ordre d'apparition dans la séquence définit l'ordre d'apparition dans le document des ensembles d'éléments correspondant aux composants du groupe de type séquence, et en ce que la séquence d'instructions qui est générée pour une séquence comprenant n composants comprend successivement des séquences d'instructions qui sont générées pour chaque composant de la séquence.

Selon encore une autre particularité de l'invention, chaque composant du schéma de structure correspond à un ensemble d'éléments comprenant au moins un élément d'informations, en ce que le schéma de structure du document à compresser comprend au moins un composant de type groupe de composants alternatifs, chaque composant alternatif correspondant à un ensemble d'éléments d'informations, le composant de type groupe de composants alternatifs correspondant dans le document à l'un des ensembles d'informations correspondant aux composants alternatifs, et en ce que la séquence d'instructions qui est générée pour un groupe de composants alternatifs comprenant n composants définissant respectivement n ensembles d'éléments, comprend successivement :

- une instruction d'insertion d'un code de numéro d'ensemble d'éléments désignant l'ensemble d'éléments apparaissant dans le document parmi les n ensembles d'éléments, associée à la taille en nombre de bits de ce code, et
- des instructions de test de la valeur du code de numéro d'ensemble d'éléments, chaque instruction de test étant associée à une séquence d'instructions qui est générée pour le composant correspondant à l'ensemble d'éléments correspondant à la valeur testée du code de numéro d'ensemble d'éléments.

Selon encore une autre particularité de l'invention, chaque composant du schéma de structure correspond à un ensemble d'éléments comprenant au moins un élément d'informations, en ce que le schéma de structure du document à compresser comprend au moins un groupe de type non ordonné de composants, chaque composant du groupe non ordonné correspondant à un ensemble d'éléments et le groupe de type groupe non ordonné correspondant dans le document à un groupe rassemblant dans un ordre quelconque tous les ensembles d'éléments correspondant aux composants du groupe de type non ordonné, et en ce que la séquence d'instructions qui est générée pour un groupe de type non ordonné comportant n composants correspondant dans le document respectivement à n ensembles d'éléments, comprend successivement :

- une instruction d'insertion d'un code de numéro d'ensemble d'éléments et désignant le prochain ensemble d'éléments apparaissant dans le document, associée à la taille en nombre de bits de ce code, et
- des instructions de test de la valeur du code de numéro d'ensemble d'éléments, chaque instruction de test étant associée à une séquence d'instructions qui est générée pour le composant correspondant à l'ensemble d'éléments correspondant à la valeur de code de numéro d'ensemble d'éléments testée, et une séquence d'instructions qui est générée pour un groupe de type non ordonné comprenant tous les composants du groupe non ordonné sauf le composant correspondant à l'ensemble d'éléments.

L'invention concerne également un procédé de décompression d'un document structuré comprenant des éléments d'informations imbriqués les uns dans les autres et associés chacun à un type d'information, le document structuré étant associé à au moins un schéma de structure définissant une structure arborescente du document et comprenant des composants de structure imbriqués les uns dans les autres, chaque type d'information du document étant défini par un composant du schéma.

Selon l'invention ce procédé comprend des étapes consistant à :

- analyser le schéma de structure du document générer, pour chaque composant du schéma de structure, une séquence d'instructions exécutables, comportant des instructions de lecture dans un flux binaire constituant le document compressé, de codes de contrôle et de valeurs compressées d'éléments d'informations ou de codes d'appel de séquences d'instructions de composant, et des instructions de contrôle du déroulement de l'exécution de la séquence en fonction des valeurs des codes de contrôle, l'exécution des séquences d'instructions sur le document compressé permettant de reconstituer un document au format du document d'origine et ayant une structure au moins équivalente,

- exécuter sur le flux binaire constituant le document à décompresser les séquences d'instructions générées, pour obtenir un document structuré au format du document structuré d'origine et ayant une structure au moins équivalente.

Avantageusement, ce procédé comprend en outre une étape d'exécution des séquences d'instructions sur le flux binaire constituant le document à décompresser.

Selon une particularité de l'invention, le document structuré comprenant des éléments de base non décomposés en sous-éléments, au moins un type d'information des éléments de base est associé à un algorithme de décompression adapté au type d'information, le procédé comprenant, durant l'exécution des séquences d'instructions sur le flux binaire constituant le document compressé, la détection dans le flux binaire d'un code binaire d'élément d'informations correspondant audit type d'information, et l'application de l'algorithme de décompression à ce code binaire.

Selon une autre particularité de l'invention, le procédé comprend une étape de compilation des séquences d'instructions obtenues pour chaque composant dudit schéma de structure, pour obtenir un programme binaire de décodage dédié audit schéma de structure, et directement exécutable ou interprétable par un calculateur pour décompresser un document ayant ce schéma de structure.

Selon encore une autre particularité de l'invention, le procédé comprend une étape préalable de normalisation du schéma de structure du document, de manière à obtenir un ordre unique prédéfini des composants du schéma.

Selon encore une autre particularité de l'invention, le procédé comprend une étape préalable d'optimisation et de simplification du schéma de structure du document consistant à réduire le nombre de niveaux hiérarchiques de groupes de composants de structure.

Avantageusement, au moins un code d'élément d'informations est repéré dans le flux binaire du document compressé, de manière à permettre l'accès direct à cet élément d'informations, sans qu'il soit nécessaire de décompresser les éléments d'informations précédant cet élément dans le flux binaire.

Selon encore une autre particularité de l'invention, le document compressé comprend pour chaque élément d'informations du document d'origine, un code permettant de déterminer le type d'information associé à l'élément d'informations et la valeur binaire de l'élément d'informations compressé.

Selon encore une autre particularité de l'invention, le schéma de structure du document à décompresser comprend la définition de sous-types d'au moins un type d'information, et en ce que la séquence d'instructions qui est générée pour un composant d'un type ayant n sous-types comprend successivement :

- une instruction de lecture d'un code de sous-type représentant un numéro du sous-type à appliquer à un élément correspondant dans le document au composant, associée à la taille de ce code en nombre de bits, et
- des instructions de test de la valeur du code de sous-type, chaque instruction de test étant associée à une référence au sous-type de l'élément correspondant à la valeur du code de sous-type testée, et à une séquence d'instructions qui est générée pour la décompression d'un élément associé au sous-type.

De préférence, dans le flux binaire du document compressé, la fin d'un groupe de plusieurs occurrences d'un ensemble d'éléments comportant au moins un élément d'informations et correspondant à un composant du schéma, est marquée par un code binaire déterminé.

Selon encore une autre particularité de l'invention, chaque composant du schéma de structure correspond dans le flux binaire du document à un ensemble d'éléments comprenant au moins un élément d'informations, et est en outre associé à un ensemble de nombres d'occurrences possibles, indiquant le nombre de fois qu'un ensemble d'éléments correspondant à ce composant de structure, peut apparaître dans l'élément d'informations de niveau immédiatement supérieur auquel il appartient.

Selon encore une autre particularité de l'invention, la séquence d'instructions qui est générée pour un composant ayant un nombre d'occurrences égal à 0 ou 1 comprend successivement :

- une instruction de lecture d'un code de présence sur un bit indiquant la présence ou non dans le document compressé d'un ensemble d'éléments correspondant au composant,
- une instruction de test de la valeur du code de présence, et
- en association avec l'instruction de test, si la valeur du code de présence indique la présence de l'ensemble d'éléments dans le document compressé, une séquence d'instructions qui est générée pour le composant, indépendamment du nombre d'occurrences associé.

Selon encore une autre particularité de l'invention, la séquence d'instructions qui est générée pour un composant ayant un nombre d'occurrences compris entre n et m comprend successivement :

- une instruction de lecture d'un code de nombre d'occurrences indiquant le nombre d'occurrences successives dans le document compressé d'un ensemble d'éléments correspondant au composant, auquel on a retranché le nombre n minimum d'occurrences, associée à la taille de ce code en nombre de bits,
- une instruction de boucle définissant un nombre d'itérations correspondant à la valeur du code de nombre d'occurrences, et
- en association avec l'instruction de boucle, une séquence d'instructions qui est générée pour le composant, indépendamment du nombre d'occurrences associé.

Selon encore une autre particularité de l'invention, la séquence d'instructions qui est générée pour un composant ayant un nombre d'occurrences compris entre 0 et m comprend en outre :

- une instruction de lecture d'un code de présence indiquant sur un bit la présence ou non dans le document compressé d'au moins une occurrence d'un ensemble d'éléments correspondant au composant, et
- une instruction de test de la valeur du code de présence, associée à la séquence d'instructions générée pour un nombre d'occurrences compris entre 1 et m du composant, si la valeur du code de présence indique la présence d'au moins un ensemble d'éléments.

Selon encore une autre particularité de l'invention, la séquence d'instructions qui est générée pour un composant ayant un nombre d'occurrences compris entre n et m comprend successivement :

- une instruction de lecture d'un code de présence sur un bit d'une occurrence d'un ensemble d'éléments correspondant au composant dans le document compressé, associée à la taille de ce code en nombre de bits,
- une instruction de boucle à exécuter tant que le code de présence lu dans le flux binaire du document compressé indique la présence d'une nouvelle occurrence de l'ensemble d'éléments,
- en association avec l'instruction de boucle, une séquence d'instructions qui est générée pour le composant, et une instruction d'insertion d'un nouveau code de présence sur un bit d'une nouvelle occurrence de l'ensemble d'éléments dans le document compressé.

Selon encore une autre particularité de l'invention, chaque composant du schéma de structure correspond à un ensemble d'éléments comprenant au moins un élément d'informations, en ce que le schéma de structure du document compressé comprend au moins un composant de type séquence de composants ordonnés, dont l'ordre d'apparition dans la séquence définit l'ordre d'apparition dans le document des ensembles d'éléments correspondant aux composants du groupe de type séquence, et en ce que la séquence d'instructions qui est générée pour une séquence comprenant n composants comprend successivement des séquences d'instructions qui sont générées pour chaque composant de la séquence.

Selon encore une autre particularité de l'invention, que chaque composant du schéma de structure correspond à un ensemble d'éléments comprenant au moins un élément d'informations, en ce que le schéma de structure du document à décompresser comprend au moins un composant de type groupe de composants alternatifs, chaque composant alternatif correspondant à un ensemble d'éléments d'informations, le composant de type groupe de composants alternatifs correspondant dans le document à l'un des ensembles d'informations correspondant aux composants alternatifs, et en ce que la séquence d'instructions qui est générée pour un groupe de composants alternatifs comprenant n composants définissant respectivement n ensembles d'éléments, comprend successivement :

- une instruction de lecture d'un code de numéro d'ensemble d'éléments désignant l'ensemble d'éléments apparaissant dans le document parmi les n ensembles d'éléments, associée à la taille en nombre de bits de ce code, et
- des instructions de test de la valeur du code de numéro d'ensemble d'éléments, chaque instruction de test étant associée à une séquence d'instructions qui est générée pour le composant correspondant à l'ensemble d'éléments correspondant à la valeur testée du code de numéro d'ensemble d'éléments.

Selon encore une autre particularité de l'invention, chaque composant du schéma de structure correspond à un ensemble d'éléments comprenant au moins un élément d'informations, en ce que le schéma de structure du document à décompresser comprend au moins un groupe de type non ordonné de composants, chaque composant du groupe non ordonné correspondant à un ensemble d'éléments et le groupe de type groupe non ordonné correspondant dans le document à un groupe rassemblant dans un ordre quelconque tous les ensembles d'éléments correspondant aux composants du groupe de type non ordonné, et en ce que la séquence d'instructions qui est générée pour un groupe de type non ordonné comportant n composants correspondant dans le document respectivement à n ensembles d'éléments, comprend successivement:

- une instruction de lecture d'un code de numéro d'ensemble d'éléments et désignant le prochain ensemble d'éléments apparaissant dans le document, associée à la taille en nombre de bits de ce code, et
- des instructions de test de la valeur du code de numéro d'ensemble d'éléments, chaque instruction de test étant associée à une séquence d'instructions qui est générée pour le composant correspondant à l'ensemble d'éléments correspondant à la valeur de code de numéro d'ensemble d'éléments testée, et une séquence d'instructions qui est générée pour un groupe de type non ordonné comprenant tous les composants du groupe non ordonné sauf le composant correspondant à l'ensemble d'éléments.

Un mode de réalisation préféré de l'invention sera décrit ci-après, à titre d'exemple non limitatif, avec référence aux dessins annexés dans lesquels :

La figure 1 représente sous la forme d'un schéma-bloc l'enchaînement des différentes étapes du procédé selon l'invention ;

Les figures 2a, 2b et 2c représentent graphiquement un schéma de structure sous la forme d'un arbre ;

La figure 3 montre un schéma de structure obtenu en appliquant une méthode de réduction selon l'invention au schéma de structure représenté sur la figure 2 ;

Les figures 4a, 4b et 4c montrent un schéma de structure obtenu en appliquant une autre méthode de réduction selon l'invention au schéma de structure représenté sur la figure 2.

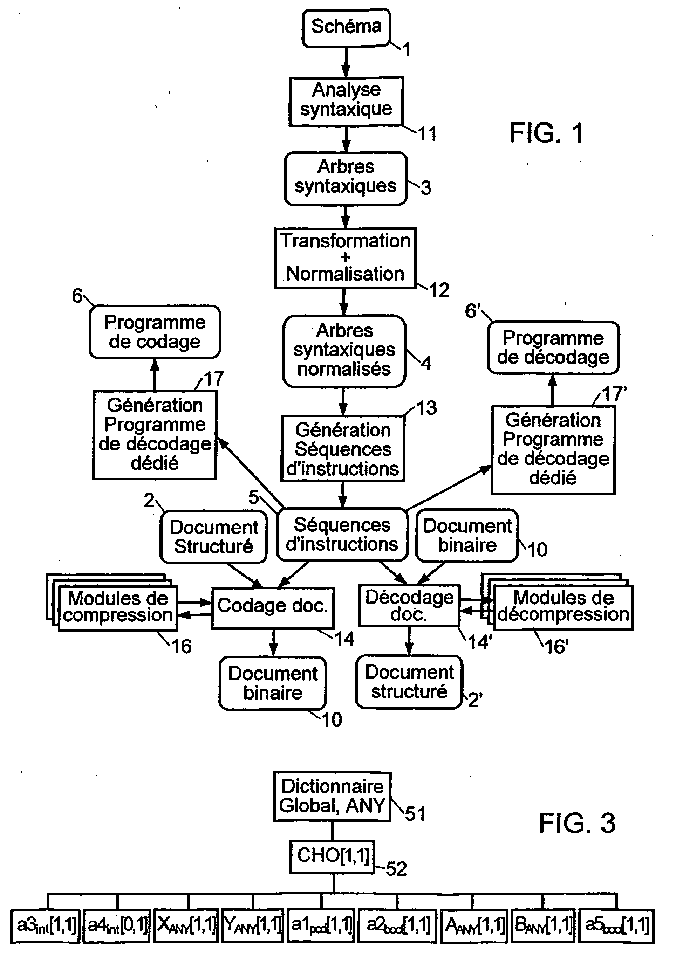

La figure 1 représente l'enchaînement des différentes étapes du procédé selon l'invention.

Ce procédé est conçu pour traiter un document structuré constitué d'un schéma de structure 1 définissant la structure du document et des informations structurées 2 du document.

Dans le langage XML-Schema, un schéma de structure présente par exemple la forme suivante :

```
<element name="C">
  <complexType>
    <Choice>
      <element name="A" type="TA" minOccurs=1 maxOccurs=1/>
      <element name="B" type="TB" minOccurs=1 maxOccurs=1/>
    </Choice>
    <attribute name="a2" required=false type="boolean"/>
    <attribute name="a1" required=true type="integer"/>
  </complexType>
</element>
```

Ce schéma indique que le composant de structure nommé "C" présente une structure complexe constituée d'un premier attribut nommé "a2" de type booléen qui est optionnel, d'un second attribut nommé "al" de type entier qui est toujours présent dans la structure, et d'un groupe de composants alternatifs nommés "A" et "B" de types respectifs "TA" et "TB", l'un des ces deux composants étant présent une seule fois dans la structure.

Les types "TA" et "TB" sont définis dans le schéma de structure du document par une formulation analogue.

D'une manière générale, on utilise des composants particuliers appelés groupes de composants pour définir une structure de document. Ces groupes de composants peuvent être du type :

- SEQ : qui définit une liste de composants ordonnés dont les élément correspondants dans le document doivent tous apparaître et dans l'ordre indiqué,
- CHO : qui définit un groupe de composants alternatifs, un seul élément correspondant à un composant du groupe devant apparaître dans le document,
- ET : qui définit un groupe de composants dont les éléments correspondants doivent tous apparaître dans le document et dans un ordre quelconque qui ne doit pas être modifié ; ce groupe correspond au groupe "all" dans la norme XML Schema,
- $ET_{NO}$ : qui définit un groupe de composants dont les éléments correspondants doivent tous être présents dans le document dans un ordre quelconque qui n'a pas d'importance ; ce groupe peut être utilisé pour le codage des attributs dont l'ordre n'a pas d'importance dans la norme XML, et
- ANY : qui comprend un élément quelconque parmi tous les éléments possibles que l'on peut trouver dans le document.

Selon l'invention, cette formulation est analysée et transformée à l'étape 11 du procédé pour obtenir des arbres syntaxiques 4, à raison d'un arbre par composant de structure. L'arbre syntaxique correspondant au composant de structure TC est symbolisé par l'expression suivante :

$TC \rightarrow SEQ[1,1](ET_{NO}[1,1](a1_{int}[1,1],a2_{bool}[0,1]),CHO[1,1](A_{TA}[1,1],B_{TB}[1,1]))$

dans laquelle :

"A[x,y]" indique que le composant "A" correspond à un élément répété de x à y fois dans le document, y pouvant être égal à "*" représentant une valeur indéterminée.

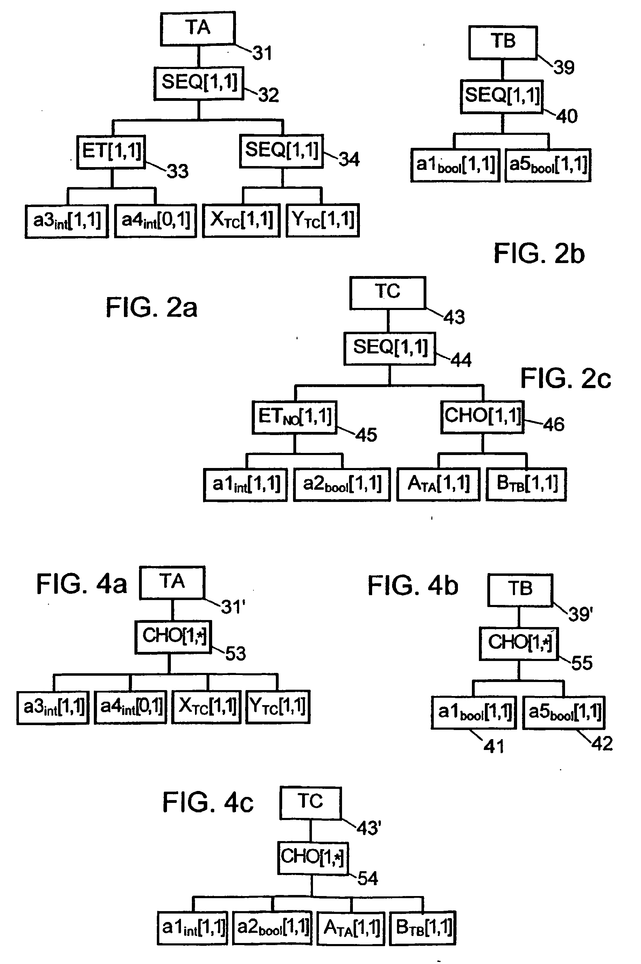

Cette expression peut être représentée par l'arbre montré sur la figure 2c, comprenant un composant racine "TC" 43 constitué d'une occurrence unique d'un groupe de composants de type séquence 44. Ce groupe comprend une occurrence unique d'un groupe de composants de type "ET" non ordonné 45 et une occurrence unique d'un groupe de composants alternatifs 46. Le groupe 45 est constitué d'une occurrence unique d'un entier nommé "al" et d'un booléen nommé "a2", et le groupe 46 comprend une occurrence unique d'un élément nommé "A" de type "TA" et d'un élément nommé "B" de type "TB".

Les types "TA" et "TB" obtenus à l'étape 11 sont par exemple donnés par les formules suivantes :

$TA \rightarrow SEQ[1,1](ET[1,1](a3_{int}[1,1],a4_{int}[0,1]),SEQ[1,1](X_{TC}[1,1],Y_{TC}[1,1]))$

$TB \rightarrow SEQ[1,1](a1_{bool}[1,1], a5_{bool}[1,1])$ et représentés par les arbres montrés respectivement sur les figures 2a et 2b.

Le type "TA" 31 comprend un groupe unique 32 de type séquence constitué de deux groupes uniques 33, 34, respectivement de type ET et SEQ. Le groupe 33 comprend deux occurrences uniques de type entier, nommées respectivement "a3" et "a4". Le groupe 34 comprend deux occurrences uniques de type "TC" nommées respectivement "X" et "Y".

Le type "TB" 39 est constitué d'un groupe unique 40 de type séquence comprenant deux booléens respectivement nommés "a1" et "a5".

Bien que dans la description qui précède, on a distingué le nom de chaque élément et son type, le procédé selon l'invention s'applique également aux langages de structuration qui ne font pas cette distinction.

En outre, certains langages comme le langage XML Schéma autorisent ce que l'on appelle le polymorphisme ou l'utilisation de sous-types.

De tels sous-types sont définis de la manière suivante :

```
<complexType name="TA1">
        <restriction base="TA">
        </restriction>
</complexType>


<complexType type="TA2">
        <extension base="TA">
        </extension>
</complexType>
<element name="X" type="TA"/>
```

Cette syntaxe définit les types TA1 et TA2 comme des sous-types du type TA par restriction ou extension, et le composant d'informations X de type TA.

Un document ayant ce schéma de structure peut comprendre un élément X de type TA1 qui peut être introduit de la manière suivante :

```
<X xsi:type="TA1">
```

De plus certains types possédant ainsi des sous-types peuvent être déclarés abstraits, ce qui signifie que les éléments d'informations dans un document ayant un schéma de structure comprenant la définition d'un type abstrait ne peuvent pas contenir des éléments d'information ayant ce type. En fait, les types abstraits ne sont utilisés que pour créer des hiérarchies ou des classes de types. Un type abstrait est défini dans le langage XML Schéma de la manière suivante :

```
<complexType name="a" type="TA" abstract="true">
</complexType>
```

Par ailleurs, les composants de structure doivent être déterministes, c'est-à-dire qu'un élément du document ne doit pas pouvoir être interprété de plusieurs manières différentes. Par exemple, dans le schéma "CHO(a,SEQ(a,b))", dans le cas où "a" apparaît dans le document, on ne sait pas si "b" doit apparaître ensuite. Il existe à cet effet des algorithmes qui peuvent être appliqués par le procédé selon l'invention pour transformer un schéma non déterministe en un schéma déterministe. On peut par exemple se référer aux documents ["Regular expressions into finite automata" Brüggemann-Klein, Anne, Extended Abstract in I. Simon, Hrsg., LATIN 1992, S. 97-98. Springer-Verlag, Berlin 1992. Full Version in Theoretical Computer Science 120: 197-213, 1993]. Ainsi, le schéma ci-avant peut par exemple être remplacé par "SEQ(a,b[0,1])".

A l'étape 12 suivante du procédé selon l'invention, les composants du schéma de structure transformés en arbres syntaxiques peuvent tout d'abord subir un traitement de réduction ou de simplification.

Ce traitement de réduction peut consister par exemple à effectuer un aplatissement global en générant un seul arbre syntaxique 51 à partir de tous les arbres 31, 39 et 43, comme cela est représenté sur la figure 3.

Cet arbre représente en fait un dictionnaire de tous les types d'éléments susceptibles d'être rencontrés dans le document, ces éléments étant rassemblés dans un groupe 52 de type alternatif apparaissant au moins une fois [1,*] dans le document. Dans cet arbre, les composants de type complexe "A", "B", "X" et "Y" sont associés à un type "ANY", et le composant "a1" qui apparaissait deux fois (dans les composants "TB" et "TC") avec des types différents, est associé à un type par défaut "pcdata" selon le langage XML ou au type de l'élément dans le document initial, par exemple texte. Un même élément d'informations peut en effet être représenté de plusieurs manières : par exemple une séquence binaire peut également être considérée comme une chaîne de caractères ou un nombre entier.

Alternativement, ce traitement de réduction consiste à aplatir localement les arbres syntaxiques pour obtenir les arbres représentés 31', 39' et 43' sur les figures 4a à 4c.

Dans chacune de ces figures, les groupes 32 à 34 (figure 2a), 40 (figure 2b) et 44 à 46 (figure 2c) ont été respectivement remplacés par un groupe 53, 54, 55 de type alternatif apparaissant au moins une fois [1,*].

Les arbres "TA", "TB" et "TC" peuvent en outre subir un traitement supplémentaire pour supprimer les ambiguïtés apparaissant dans le schéma de structure.

Dans certains cas, les arbres syntaxiques peuvent être simplifiés d'une manière non destructive, tout en améliorant la compacité du code binaire qui pourra être généré.

Une telle simplification peut être effectuée dans le cas d'un groupe de composants contenant un seul composant X dont le nombre minimum d'occurrences $n_X$ est égal à 0 ou 1, de la forme :

$GROUP[n_G,m_G](X[n_X,m_X])$

dans laquelle GROUP peut être un groupe de type SEQ, CHO ou ET. Un tel groupe peut être remplacé par le composant suivant :

$X[n_G,n_X,m_G,m_X$

Un autre cas de simplification non destructive est possible dans le cas d'un groupe de composants alternatifs CHO comprenant au moins un composant dont le nombre d'occurrences minimum est égal à 0. Ainsi, le groupe :

$CHO[n_C,m_C](X1[n_{X1},m_{X1}], X2[0,m_{X2}], X3[n_{X3},m_{X3}])$

peut être remplacé par :

$CHO[0,m_C](X1[n_{X1},m_{X1}], X2[1,m_{X2}], X3[n_{X3},m_{X3}])$

De même, un groupe $CHO[1,1](.., CHO[1,1](...), ...)$ d'une unique occurrence de type CHO contenant notamment une unique occurrence de type CHO, peut être simplifié en étant remplacé par un groupe unique $CHO[1,1](...)$ de type CHO contenant tous les composants des deux groupes de type CHO.

A l'étape 12, les arbres "TA", "TB" et "TC" subissent également un traitement de normalisation qui consiste à réordonner le schéma de manière à obtenir un ordre unique des composants du schéma. Ce traitement affecte ensuite un numéro binaire aux différents noeuds des arbres syntaxiques obtenus à la suite des traitements précédents. Ce numéro est utilisé lors de la compression de l'élément d'information correspondant.

Le traitement de normalisation consiste en particulier à attribuer à chaque groupe une signature constituée de la concaténation du nom du groupe avec la signature de tous les composants du groupe, préalablement ordonnés. Ainsi, le groupe 53 sur la figure 4 est associé à la signature "CHO.a3.a4.X.Y".

Lors de ce traitement, on considère que les groupes ordonnés (SEQ) sont déjà normalisés. Les groupes à normaliser sont donc les groupes de type alternatif ("CHO"), et les groupes "ET" et "ET$_{NO}$". Ce traitement comprend les étapes suivantes pour chaque groupe G composé de sous-groupes $g_i$ et de composants $e_i$ définissant un élément respectif dans le document :

- la normalisation des sous-groupes $g_i$ éventuels du groupe G avant de normaliser le groupe G, l'algorithme de normalisation étant récursif,
- le rangement des composants $e_i$ éventuels du groupe G avant les sous-groupes $g_i$,
- le rangement des composants $e_i$ dans un ordre prédéfini,
- le rangement des sous-groupes $g_i$ dans l'ordre prédéfini, et
- la détermination de la signature du groupe G donnée par la concaténation de toutes les signatures de ses composants (et sous-groupes) suivant l'ordre établi à la suite des étapes précédentes.

L'ordre prédéfini de rangement des composants du groupe peut être l'ordre alphanumérique de leurs signatures respectives, ou l'ordre décroissant de leur nombre minimal d'occurrences, les composants ayant le même nombre minimal d'occurrences étant ensuite rangés par ordre alphanumérique.

Il est à noter que ce traitement de normalisation n'est pas nécessaire dans le procédé selon l'invention. L'ordre d'apparition des composants dans le schéma peut en effet être conservé.

L'étape 13 suivante du procédé consiste à générer une séquence d'instructions 5, également appelée "syntaxe binaire", décrivant un flux binaire. Ce traitement consiste à générer pour chaque arbre syntaxique ou type complexe du schéma de structure une séquence d'instructions, en commençant par les noeuds ou composants de plus bas niveau dans les arbres syntaxiques du schéma de structure arborescente du document. Des instructions d'appel aux syntaxes binaires ainsi générées pour les noeuds de bas niveau, sont insérées ensuite dans les syntaxes binaires des noeuds de plus haut niveau dans lesquels les composants de bas niveau apparaissent. De cette manière, on obtient une syntaxe binaire pour l'ensemble du schéma de structure du document, laquelle appelle les syntaxes binaires des composants de plus bas niveau, d'une manière analogue à un logiciel comprenant un programme principal qui appelle des sous-programmes, lesquels peuvent également appeler d'autres sous-programmes, et ainsi de suite.

La syntaxe binaire d'un composant représentant un élément X de type TX est de la forme suivante :

| X | TX |
|---|---|

dans laquelle "X" représente une instruction d'insertion ou de lecture de la valeur de l'élément X ou l'appel de la séquence d'instructions correspondant à l'élément X, et "TX" représente une référence au type de l'élément X.

Si le type TX possède un ou plusieurs sous-types, il représente ce que l'on appelle un polymorphisme. Dans ce cas, il est associé à la syntaxe binaire suivante :

| X | TX_poly |
|---|---|

Si le type TX comporte les sous-types S1, S2, ..., Sn, il faut considérer deux cas selon que le type TX par défaut est abstrait ou non.

Si le type TX par défaut est abstrait, on génère une syntaxe binaire "TX_poly" comprenant successivement :

- une instruction d'insertion ou de lecture d'un code de sous-type "flagPoly" représentant un numéro du sous-type à appliquer à l'élément X, associée à la taille de ce code en nombre de bits, et
- des instructions de test de la valeur du code de sous-type, chaque instruction de test étant associée à une instruction d'insertion ou de lecture de la valeur de l'élément X ou l'appel de la séquence d'instructions correspondant à l'élément X, associée à une référence au sous-type de l'élément X correspondant à la valeur du code de sous-type testée.

Les sous-types S1, ..., Sn sont au préalable rangés dans l'ordre de leurs signatures respectives :

Une telle syntaxe binaire est par exemple de la forme suivante :

Table 1

| flagPoly | $E(\log_2(n))$ bits |
|---|---|
| if (flagPoly == 0) { | |
| X | $S_1$ |
| } | |
| else if (flagPoly == 1) { | |
| X | $S_2$ |
| } | |
| ... | |
| else if (flagPoly == k) { | |
| X | $S_{k+1}$ |
| } | |
| ... | |
| else if (flagPoly == n-1) { | |
| X | $S_n$ |
| } | |

E() étant la fonction arrondi à l'entier supérieur, et "flagPoly" contenant le code du numéro du sous-type à appliquer à l'élément X, et "X" indiquant les emplacements où doit être inséré le code de l'élément X.

Si $2^{E(\log_2(n))} > n$, on peut ajouter la ligne suivante à la fin de la syntaxe binaire pour détecter des dysfonctionnements :

| Else | SpecificProcess |
|------|-----------------|

"SpecificProcess" étant une procédure conçue pour signaler une erreur de traitement dans le cas où "flagPoly" n'a pas une valeur correspondant à un sous-type de TX.

Si le type par défaut TX n'est pas abstrait, la syntaxe binaire de TX_poly est obtenue en insérant la syntaxe binaire précédente dans une syntaxe binaire comprenant successivement :

- une instruction d'insertion ou de lecture d'un code de présence de sous-typage "typeInfoFlag" indiquant sur un bit si le type de l'élément est le type par défaut ou un sous-type de celui-ci, et
- une instruction de test de la valeur du code de présence de sous-typage, et
- en association avec l'instruction de test, la séquence d'instructions définissant le polymorphisme telle que celle indiquée dans la table 1, si la valeur du code de présence de sous-typage indique que le type de l'élément est un sous-type, et dans le cas contraire, une instruction d'insertion ou de lecture de la valeur de l'élément X, associée à une référence au type par défaut de l'élément X.

Une telle syntaxe binaire est par exemple de la forme suivante :

### Table 2

| typeInfoFlag | 1 bit |
|--------------|-------|
| if (typeInfoFlag) { | |
| Syntaxe binaire du polymorphisme | |
| } | |
| else | |
| X | TX |

dans laquelle "typeInfoFlag" est un code indiquant si X a le type TX ou l'un des sous-types de TX.

Ensuite, on détermine la syntaxe binaire du nombre d'occurrences [n,m] de chaque élément ou ensemble d'éléments X dont on a déterminé la syntaxe binaire. Dans ce qui suit, un élément peut représenter un ensemble d'éléments.

A cet effet, on distingue trois cas. Dans le premier cas, m et n sont égaux à 1, c'est-à-dire que composant X est associé aux nombres d'occurrences [1,1]. La syntaxe binaire produite correspond à la celle qui a été générée pour le composant X.

Dans le second cas, n = 0 et m = 1, la syntaxe binaire générée comprend successivement :

- une instruction d'insertion ou de lecturé d'un code de présence "flagX" indiquant sur un bit la présence ou non de l'élément X dans le document compressé, associée à la taille de ce code en nombre de bits,
- une instruction de test de la valeur du code de présence, et
- en association avec l'instruction de test, une instruction d'insertion ou de lecture de la valeur de l'élément X ou l'appel de la séquence d'instructions correspondant à l'élément X, si la valeur du code de présence indique la présence de l'élément X dans le document.

Une telle syntaxe binaire est par exemple de la forme suivante :

## Table 3

| FlagX | 1 bit |
|---|---|
| if (flagX) { | |
| syntaxe binaire de X | |
| } | |

dans laquelle flagX est un code sur un bit indiquant la présence ou non de X dans le document. Cette syntaxe binaire est analogue à une séquence d'instructions de programmation, dans laquelle X est inséré si la valeur de l'indicateur flagX est à "vrai".

Dans le troisième cas, m-n est inférieur à une constante de seuil prédéterminée, par exemple $2^{16}$ (=65536), ce qui signifie que le nombre d'occurrences peut être codé sous la forme d'un entier non signé sur 16 bits. Dans ce cas, la syntaxe binaire de l'élément X[n, m] comprend successivement :

- une instruction d'insertion ou de lecture d'un code de nombre d'occurrences "loopflagX" indiquant le nombre d'occurrences successives de l'élément X dans le document compressé, auquel on a retranché le nombre n minimum d'occurrences de l'élément X, associée à la taille de ce code en nombre de bits,
- une instruction de boucle définissant un nombre d'itérations correspondant à la valeur du code de nombre d'occurrences, et
- en association avec l'instruction de boucle, une instruction d'insertion ou de lecture de la valeur de l'élément X ou l'appel d'une séquence d'instructions correspondant à l'élément X.

Une telle syntaxe binaire est par exemple de la forme suivante :

## Table 4

| loopflagX | $E(\log_2(m-n+1))$ bits |
|---|---|
| for (k=0;k<loopFlagX+n;k++) { | |
| syntaxe binaire de X | |
| } | |

dans laquelle "loopFlagX" est le code du nombre d'occurrences successives de X dans le document, auquel on a retranché le nombre n minimum d'occurrences de X, et E() est la fonction arrondi à l'entier supérieur.

Cette syntaxe indique que "loopflagX" est codé sur $E(\log_2(m-n+1))$ bits et que X doit être inséré un nombre de fois égal à (loopflagX + n).

Dans le quatrième cas, m n'est pas borné ou m - n est supérieur la constante de seuil prédéterminée. La syntaxe binaire générée est analogue à celle du troisième cas, à la différence que "loopflagX" n'est pas codé sur $E(\log_2(m-n+1))$ bits, mais dans un autre format permettant de coder n'importe quel entier.
Ce format peut par exemple être le format "UINT_VLC" constitué d'ensembles d'un nombre prédéterminé de bits, par exemple 5 bits, le premier bit de chaque ensemble indiquant si oui ou non cet ensemble est le dernier du code du nombre entier, et les quatre bits suivants de l'ensemble étant utilisés pour coder le nombre entier.

Dans le troisième et quatrième cas, si le nombre d'occurrence minimum n est nul, on ajoute de préférence une syntaxe binaire comprenant en outre :

- une instruction d'insertion ou de lecture d'un code de présence "shuntflagX" indiquant sur un bit la présence ou non d'au moins un élément X dans le document compressé, et
- une instruction de test de la valeur du code de présence, associée à la séquence d'instructions générée pour un nombre d'occurrences compris entre 1 et m de l'élément X, si la valeur du code de présence indique la présence d'au moins un élément X.

Une telle syntaxe binaire est par exemple de la forme suivante :

**Table 5**

| shuntFlagX | 1 bit |
|---|---|
| if (shuntFlagX){ | |
| syntaxe binaire de X[n,m] | |
| } | |

dans laquelle "shuntFlag" désigne un code sur 1 bit indiquant si oui ou non le nombre d'occurrences est nul, et la ligne "syntaxe binaire de X[n, m]" est la syntaxe binaire du nombre d'occurrences de X correspondant au troisième ou au quatrième cas.

Alternativement, on peut choisir un autre type de codage dans lequel il n'est pas nécessaire d'introduire le nombre d'occurrences des éléments d'un schéma de structure. Ce type de codage utilise une syntaxe binaire comprenant successivement :

- une instruction d'insertion ou de lecture d'un code de présence "flagX" sur un bit d'une occurrence de l'élément X dans le document, associée à la taille de ce code en nombre de bits,
- une instruction de boucle à exécuter tant que le code de présence à insérer ou lu indique la présence d'une nouvelle occurrence de l'élément X,
- en association avec l'instruction de boucle, une instruction d'insertion ou de lecture de la valeur de l'élément X ou l'appel d'une séquence d'instructions correspondant à l'élément X, et une instruction d'insertion ou de lecture d'un nouveau code de présence "flagX" sur un bit d'une nouvelle occurrence de l'élément X dans le document.

Une telle syntaxe binaire est par exemple de la forme suivante :

**Table 6**

| FlagX | 1 bit |
|---|---|
| while(flagX) { | |
| Syntaxe binaire de X | |

| FlagX | 1 bit |
|---|---|
| } | |

Cette solution présente l'avantage de ne pas avoir à analyser tout le schéma de structure du document pour déterminer les nombres d'occurrences minimum et maximum de chaque élément de la structure.

La syntaxe binaire d'un groupe de type séquentiel SEQ(X1, X2, ..., Xn) comprend successivement des séquences d'instructions générées respectivement pour les composants du groupe de type séquence, ou l'appel de ces séquences d'instructions.

Une telle syntaxe binaire est par exemple de la forme suivante :

Table 7

| syntaxe binaire de X1 |
|---|
| syntaxe binaire de X2 |
| ... |
| syntaxe binaire de Xn |

La syntaxe binaire d'un groupe de type alternatif CHO(X1, X2, ..., Xn) comprend successivement :

- une instruction d'insertion ou de lecture d'un code de numéro composant "flagChoX" représentant un numéro de composant Xi (i = 1 ... n) et désignant le prochain élément Xi du groupe à insérer ou à lire dans le document compressé, associée à la taille en nombre de bits de ce code, et
- des instructions de test de la valeur du code de numéro d'élément, chaque instruction de test étant associée à une instruction d'insertion ou de lecture de la valeur de l'élément Xi ou l'appel d'une séquence d'instructions correspondant à l'élément Xi correspondant à la valeur de code de composant testée.

Une telle syntaxe binaire est par exemple de la forme suivante :

### Table 8

| flagChoX | $E(\log_2(n))$ bits |
|---|---|
| if (flagCho==0) { | |
| syntaxe binaire de X1 | |
| } | |

| elseif (flagCho==1) { | |
|---|---|
| syntaxe binaire de X2 | |
| } | |
| ... | |
| elseif (flagCho==n-1) { | |
| syntaxe binaire de Xn | |
| } | |

dans laquelle n est le nombre de composants dans le groupe, et "flagCho" est le code de composant à sélectionner dans le groupe CHO.

Comme précédemment, si $2^{E(\log2(n))} > n$, on peut ajouter la ligne suivante à la fm de la syntaxe binaire pour détecter des dysfonctionnements :

| Else | SpecificProcess |
|---|---|

Cette instruction permet d'appeler une procédure de signalement d'erreur dans le cas où la valeur de l'indicateur "flagCho" ne correspond pas à l'un des composants attendus du groupe CHO.

Dans le cas où l'on ne code pas le nombre d'occurrences, on peut également utiliser une valeur de "flagCho" non utilisée (si $2^{E(\log2(n))} > n$) pour marquer la dernière occurrence du groupe CHO :

## Table 9

| FlagCho | E($\log_2(n)$) bits |
|---|---|
| while(FlagCho != n) { | |
| if (flagCho==0) { | |
| insertion syntaxe binaire de X1 | |
| } | |
| elseif (flagCho==1) { | |
| syntaxe binaire de X2 | |
| } | |
| ... | |
| elseif (flagCho==n-1) { | |
| syntaxe binaire de Xn | |
| } | |
| flagCho | E($\log_2(n)$) bits |
| } | |

La syntaxe binaire du groupe de type ET est générée par une procédure récursive. Elle consiste en une imbrication de groupes de types CHO, chacun déterminant quel est l'élément présent dans la description.

D'une manière plus précise, pour générer une telle syntaxe binaire, on distingue deux cas, selon que le groupe comprend un seul ou plusieurs composants. Si le groupe ne contient qu'un seul composant, la syntaxe binaire d'un tel groupe est la même que celle d'un groupe de type séquence à un seul composant.

Si le groupe contient n composants, il peut s'écrire de la forme ET($X_1$, $X_2$, ..., $X_n$). La syntaxe binaire d'un tel groupe comprend successivement :

- une instruction d'insertion ou de lecture d'un code de numéro de composant "flagChoX" représentant un numéro de composant Xi du groupe et désignant le prochain élément Xi du groupe à insérer ou à lire dans le document compressé, associé à la taille en nombre de bits de ce code, et
- des instructions de test de la valeur du code de numéro de composant, chaque instruction de test étant associée à une instruction d'insertion ou de lecture de la valeur de l'élément Xi ou l'appel d'une séquence d'instructions correspondant à l'élément Xi correspondant à la valeur de code de composant testée, et une séquence d'instructions qui est générée pour un groupe de type "groupe non ordonné" comprenant tous les composants X1, ..., Xn du groupe sauf le composant Xi.

Une telle syntaxe binaire est par exemple de la forme suivante :

### Table 10

| FlagChoX | $E(\log_2(n))$ bits |
|---|---|
| if (flagCho==0) { | |
| syntaxe binaire de $X_1$ | |
| syntaxe binaire de ET$(X_2, ..., X_n)$ | |
| } | |
| Elseif (flagCho==1) { | |
| syntaxe binaire de $X_2$ | |
| syntaxe binaire de ET$(X_1, X_3, ..., X_n)$ | |
| } | |
| ... | |
| Elseif (flagCho==k-1) { | |
| syntaxe binaire de $X_k$ | |
| syntaxe binaire de ET$(X_1, ..., X_{k-1}, X_{k+1}, ..., X_n)$ | |
| } | |
| ... | |
| Elseif (flagCho==n-1) { | |
| syntaxe binaire de $X_n$ | |
| syntaxe binaire de ET$(X_1, X_2, ..., X_{n-1})$ | |
| } | |

Cette syntaxe binaire est obtenue à partir de la syntaxe binaire d'un groupe CHO$(X_1, X_2, ..., X_n)$, dans laquelle on a ajouté, à la suite de la syntaxe binaire de chaque composant $X_k$ du groupe (k étant compris entre 1 et n), la syntaxe binaire d'un groupe ET$(X_1, ..., X_{k-1}, X_{k+1}, ..., X_n)$ dans lequel on a retiré le cbmposant $X_k$. Cette syntaxe binaire est donc récursive.

La syntaxe binaire du groupe de type ET$_{NO}$ est identique à celle d'un groupe SEQ, dans lequel on peut en outre optimiser le codage en adoptant un ordre approprié des composants du groupe.

L'étape suivante 14 consiste à relire le document 2, à compresser les données qu'il contient en exécutant les syntaxes binaires qui ont été générées sur la structure du document, en vue d'obtenir un flux binaire comportant une succession de codes binaires dans lesquels on trouve la valeur compressée de chaque élément ou élément d'informations de base du document.

Plus précisément, il s'agit de déterminer à partir du contenu du document, les valeurs à insérer dans le flux binaire, des différents codes "typeInfoFlag" "flagX", "loopflagX",... définis par les séquences binaires.

Selon un premier type de codage, ce flux binaire est de la forme $(K.N.V_1..V_N)_e$ pour chaque élément e, N étant le nombre d'occurrences de l'élément e ou le nombre d'éléments d'informations successifs correspondant à l'élément e, K étant le code permettant de déterminer l'élément e, et $V_1..V_N$ les valeurs respectives, éventuellement compressées des N occurrences de l'élément e. Si e est un groupe d'éléments, sa valeur V est décomposée en autant de séquences binaires (K.N.V) qu'il contient d'éléments. Toutefois, dans certains cas, N peut être omis, notamment lorsque ce nombre est fixe. Il en est de même de K dans le cas par exemple d'un groupe de type séquence.

A titre d'exemple de comparaison, si l'on considère le format étendu de représentation des durées, tel que défmi par la norme ISO 8601 :

sPnYnMnDTnHnMnS

dans lequel s est le signe "+" ou "-", nY représente un nombre of d'années (entier infini), nM un nombre de mois (entier infini), nD un nombre de jours (entier infini), 'T' est un caractère séparateur entre la date et le temps, nH un nombre d'heures (entier infini), nM un nombre de minutes (entier infini) et nS un nombre de secondes (décimal), tous ces éléments étant optionnels.

Ce format correspond à un schéma de structure qui peut être représenté de la manière suivante :

(\+|\-)P(\d+Y)?(\d+M)?(\d+D)?(T(\d+H)?(\d+M)?(\d+(\,\d+)?S)?)?

dans laquelle "\+" indique l'insertion du caractère "+", "(x|y)" indique l'insertion de l'élément x ou y, "?" indique que l'insertion de l'élément précédent est optionnelle, et "\d+" représente un nombre binaire sur un nombre de bits quelconque.

Cette structure correspond à la syntaxe binaire suivante :

### Table 11

| Durée | Nombre de bits |
|---|---|
| Signe | 1 |
| YearDefined | 1 |
| if (YearDefined) | |
| Années | UINT_VLC |
| MonthDefined | 1 |
| if (MonthDefined) | |
| Mois | UINT_VLC |
| DayDefined | 1 |
| if (DayDefined) | |
| Jour | UINT_VLC |
| HoursDefined | 1 |
| if (HoursDefined) | |
| Heures | UINT_VLC |
| MinutesDefined | 1 |
| if (MinutesDefined) | |
| Minutes | UINT_VLC |
| SecondsDefined | 1 |
| if (SecondsDefined) | |
| Secondes | UINT_VLC , UINT_VLC |

dans laquelle la valeur Signe vaut 0 pour représenter le signe "+" et 1 pour représenter le signe "-".

Ainsi, la durée "+P1347Y" est codée de la manière suivante :

| + | +1347Y | M | D | H | M | S |
|---|---|---|---|---|---|---|
| 0 | 1 10101 00100 00011 | 0 | 0 | 0 | 0 | 0 |

Ce codage nécessite 22 bits, tandis que le codage classique nécessite 48 bits.

La durée "-P1Y2MT2H" est codée de la manière suivante :

| - | 1Y | 2M | D | 2H | M | S |
|---|---|---|---|---|---|---|
| 1 | 1 00001 | 1 00010 | 0 | 1 00010 | 0 | 0 |

soit sur 22 bits au lieu de 72 avec le codage classique.

Au préalable, on peut réaliser un entête général du document compressé qui regroupe plusieurs paramètres codés, utiles à la description du document. Ainsi, un tel entête peut comprendre une signature du ou des schémas de structure utilisés, et un ensemble de paramètres décrivant le codage utilisé, comme par exemple :

- un paramètre indiquant si le codage de la longueur de chaque élément est obligatoire ou optionnel ou non présent dans le document,
- un paramètre indiquant si les éléments peuvent ou non être sous-typés, c'est-à-dire associés à un type plus précis que leur type de base, et

- un paramètre indiquant le type de codage utilisé pour le nombre d'occurrences.

Chaque élément d'information du document peut également être associé à un entête, sa présence et sa nature étant précisés dans l'entête du document.

L'entête d'un élément peut ainsi comprendre la longueur codée de celui-ci, de manière à permettre, lors de la décompression du document, l'accès à un élément particulier sans décompresser tous les éléments précédents dans le document. Les entetes d'éléments sont insérés dans le document par exemple juste avant le codage de la valeur des éléments.

D'une manière générale, la décompression du document consiste à lire séquentiellement le document compressé, en exécutant les syntaxes binaires générées à partir du schéma sur le flux binaire obtenu par la lecture séquentielle du document compressé. Ce traitement permet en outre de vérifier que la structure du document compressé correspond au schéma compilé en syntaxes binaires.

Lorsque le nombre d'occurrences des éléments du schéma de structure n'est pas codé, le codage des éléments n'est alors plus que de la forme KV, le codage de chaque ensemble d'éléments de même type se terminant par un bit $K_{esc}$ valant 0.

En fait, ce type de codage n'est intéressant que pour le codage de formes complexes, et pour des éléments n'ayant pas de nombre d'occurrences maximal ou un nombre d'occurrences minimum nul. Il est en particulier tout à fait adapté au codage de groupes de type alternatif comprenant un nombre d'éléments différent de $2^p$, p étant un nombre entier.

Ce type de codage peut être combiné avec le précédent. Il suffit alors pour cela, de l'indiquer dans l'entête du document compressé et d'attribuer un bit aux endroits du codage où doivent se trouver un nombre d'occurrences.

Selon l'invention, au moins un type de base des éléments d'informations du document est associé à un module externe de compression 16. De cette manière, lors de la lecture du document, les types respectifs des éléments d'informations rencontrés sont analysés, et lorsqu'un type d'information est associé à un module externe de compression 16, celui-ci est appliqué au contenu de l'élément d'information et le résultat de la compression inséré dans le document compressé en tant que valeur de l'élément d'informations correspondant.

Les modules externes de compression peuvent par exemple appliquer la norme "mp3" pour les informations sonores, "jpeg" pour les images et "MPEG 1" ou "MPEG 2" pour les données de type vidéo, ou IEEE 754 pour les valeurs de type nombre réel ou UTF8 pour les chaînes de caractères.

Si aucun module de compression n'est associé à un type d'information, on peut utiliser un module de compression par défaut ou récupérer les éléments d'informations ayant ce type tels qu'ils apparaissent dans le document initial.

Par exemple, le codage la structure CHO[0,*](a1, a2, a3) produit la syntaxe binaire suivante :

### Table 12

| loopflagCho | UINT_VLC bits |
|---|---|
| for (k=0;k<loopFlagCho;k++) { | |
| flagCho | 2 bits |

| if (flagCho==0) { | |
|---|---|
| valeur $V_{a1}$ de a1 | |
| } | |
| elseif (flagCho==1) { | |
| valeur $V_{a2}$ de a2 | |
| } | |
| elseif (flagCho==2) { | |
| valeur $V_{a3}$ de a3 | |
| } | |
| } | |

Si maintenant on souhaite coder l'occurrence "$a_2\,a_3\,a_1\,a_1\,a_3$" ayant cette structure, le résultat du codage est le suivant dans le cas où l'on code le nombre d'occurrences :

0010101 $V_{a2}$ 10 $V_{a3}$ 00 $V_{a1}$ 00 $V_{a1}$ 10 $V_{a3}$

dans lequel "00101" représente la valeur binaire du nombre d'occurrences soit 5 dans le format "UINT_VLC", et $V_{a1}$, $V_{a2}$ et $V_{a3}$ sont respectivement les valeurs des occurrences de $a_1$, $a_2$ et $a_3$.

Dans le cas où l'on ne code pas le nombre d'occurrences, le codage est le suivant :

01 $V_{a2}$ 10 $V_{a3}$ 00 $V_{a1}$ 00 $V_{a1}$ 10 $V_{a3}$ 11

"11" correspondant au code de fin du nombre d'occurrences qui est dans ce cas intégré dans le code de sélection du groupe CHO.

Dans le premier cas, on obtient un codage sur 15 bits en plus des codes des valeurs des éléments, tandis que dans le second cas, on obtient un codage plus compact sur 12 bits.

Le traitement de codage de l'occurrence "$b_2\,b_1\,a_1$" ayant pour structure :

SEQ[0,*]($a_1$[0,*],CHO[0,*]($b_1$,$b_2$)) conduit à la syntaxe binaire suivante :

### Table 13

| | |
|---|---|
| shuntFlagSeq | 1 bit |
| if (shuntFlagSeq) { | |
|     loopflagSeq | UINT_VLC bits |
|     for (k=0;k<loopFlagSeq;k++) { | |

| | |
|---|---|
|     shuntFlaga1 | 1 bit |
|     if (shuntFlaga1) { | |
|       loopflaga1 | UINT_VLC bits |
|       for (k=0;k<loopFlaga1;k++) { | |
|         code valeur $V_{a1}$ de a1 | |
|       } | |
|     } | |
|     shuntFlagCho | 1 bit |
|     if (shuntFlagCho) { | |
|       loopflagaCho | UINT_VLC bits |
|       for (k=0;k<loopFlagCho;k++) { | |
|       flagCho | 1 bit |
|       if (flagCho==0) { | |
|         code valeur $V_{b1}$ de b1 | |
|       } | |
|       elseif (flagCho==1) { | |
|         code valeur $V_{b2}$ de b2 | |
|       } | |
|       } | |
|     } | |
|     } | |
| } | |

Cette syntaxe binaire conduit au codage suivant :

| | |
|---|---|
| 1 | nombre d'occurrences de la séquence différent de 0 |
| 00010 | nombre d'occurrences de la séquence (ici 2 fois) |
| 0 | nombre d'occurrences de a = 0 |
| 1 | nombre d'occurrences de CHO différent de 0 |
| 00010 | nombre d'occurrences de CHO (2 fois) |
| 1 | code du choix de $b_2$ |
| $V_{b2}$ | codage de la valeur de $b_2$ |
| 0 | codage du choix de $b_1$ |
| $V_{b1}$ | codage de la valeur de $b_1$. |
| 1 | nombre d'occurrences de a = 0 |
| 00001 | nombre d'occurrences de $a_1$ (1 fois) |
| $V_{a1}$ | codage de la valeur de $a_1$ |
| 0 | nombre d'occurrences de CHO = 0 |

Si l'ordre des attributs n'est pas utile (comme dans le langage XML), on peut effectuer un codage qui réordonne les attributs des éléments dans un ordre prédéterminé, par exemple suivant un ordre alphanumérique, puis suivant le fait qu'ils sont requis ou non. Cette disposition permet de réduire d'autant la taille de la description compressée.

Si dans l'entête du document, il est indiqué que le codage de la longueur est optionnel ou obligatoire, les éléments sont associés à un entête dans le document compressé, contenant la longueur en nombre de bits de la valeur de l'élément. Cette particularité permet un accès direct à un élément du document compressé sans avoir à décompresser les éléments situés avant dans le document, en lisant à l'aide des syntaxes binaires uniquement les longueurs respectives de ces éléments jusqu'à l'élément recherché.

La longueur des éléments peut être codée de la manière suivante.

Dans le cas où dans l'entête du document, il est indiqué que le codage de la longueur des éléments est obligatoire, la longueur L des éléments en nombre de bits est calculée à l'aide la formule suivante :

$$L = 8*p+h \qquad\qquad (1)$$

où p représente le nombre d'octets (en codage ASN1 ou utilisant les bits de poids fort de chaque octet utilisé pour coder ce nombre) utilisés pour coder la longueur de l'élément, et h représente le nombre de bits restants de cette longueur (h < 8).

Il est à noter que le module externe de compression 16 qui est appelé pour effectuer le codage de la valeur d'un élément peut fournir en retour cette longueur.

Dans le cas où le codage de la longueur des éléments n'est pas obligatoire, la valeur du premier bit correspondant à la valeur de l'élément indique si les bits suivants représentent ou non la longueur de l'élément.

Le traitement de décompression d'un document ainsi compressé est effectué en exécutant les étapes 11 à 14 sur le schéma de structure du document pour obtenir les syntaxes binaires des composants de structure du schéma de structure du document, puis en exécutant l'étape 14' de décodage ou de décompression du document, cette étape consistant à parcourir le document compressé en exécutant les syntaxes binaires obtenues à la suite des étapes 11 à 14, de manière à pouvoir déterminer le type et le nom des éléments d'information compressés rencontrés dans le document. Les valeurs des éléments qui ont été obtenues à l'aide de modules 16 de compression externes sont décompressées à l'aide de modules de décompression 16' correspondants.

Il est à noter que si l'on doit traiter (compresser ou décompresser) plusieurs documents ayant le même schéma de structure, les étapes 11 à 13 ne sont exécutées qu'une seule fois, seules les étapes 14 et 16 (ou 14' et 16') devant être appliquées à chaque document à traiter.

En outre, par un traitement de conversion approprié, la syntaxe binaire d'un schéma de structure, qui est proche d'un langage de programmation classique, peut être compilée 17, 17' pour générer un code binaire de programme de compression ou de décompression 6, 6' directement exécutable ou interprétable par le processeur d'un calculateur. Le procédé selon l'invention permet donc de générer automatiquement des programmes de compression et de décompression exécutables, donc très rapides, dédiés à un schéma de structure donné.

## Revendications

1. Procédé de compression d'un document structuré comprenant des éléments d'informations imbriqués les uns dans les autres et associés chacun à un type d'information, le document structuré (2) étant associé à au moins un schéma de structure (1 ; 31, 39, 43) définissant une structure arborescente du document et comprenant des composants de structure (a3, a4, X, Y, a1, a5, a1, a2, A, B, 32, 33, 34, 40, 44, 45, 46) imbriqués les uns dans les autres, chaque type d'information du document étant défini par un composant du schéma,
**caractérisé en ce qu'**il comprend des étapes consistant à :

- analyser (11) le schéma de structure (1) du document générer, pour chaque composant du schéma de structure, une séquence d'instructions exécutables (5) comportant des instructions d'insertion dans un flux binaire, de codes de contrôle et de valeurs compressées d'éléments d'informations ou de codes d'appel de séquences d'instructions de composant, et des instructions de contrôle du déroulement de l'exécution de la séquence en fonction des valeurs des codes de contrôle, l'exécution des séquences d'instructions sur le document structuré (2) permettant de compresser le document structuré (2) en un flux binaire (10) contenant des valeurs compressées des éléments d'informations du document,
- exécuter (14) sur le document structuré (2) les séquences d'instructions générées, pour obtenir un flux binaire (10) contenant les valeurs compressées des éléments d'informations du document.

2. Procédé de compression selon la revendication 1,
**caractérisé en ce que**, le document comprenant des éléments de base non décomposés en sous-éléments, au moins un type d'information des éléments de base est associé au préalable à un algorithme de compression (16) adapté au type d'information, le procédé comprenant, durant l'exécution des séquences d'instructions (5), l'application de l'algorithme de compression (16) à la valeur de chaque élément d'information ayant un type d'information associé audit algorithme.

3. Procédé de compression selon la revendications 1 ou 2,
**caractérisé en ce qu'**il comprend une étape de compilation (17) des séquences d'instructions (5) obtenues pour chaque composant dudit schéma de structure, pour obtenir un programme binaire de codage (6) dédié audit schéma de structure, et directement exécutable ou interprétable par un calculateur pour compresser un document (2) ayant le schéma de structure (1).

4. Procédé de compression selon l'une des revendications 1 à 3,
**caractérisé en ce qu'**il comprend une étape préalable de normalisation (12) du schéma de structure (5) du document, de manière à obtenir un ordre unique prédéfini des composants du schéma.

5. Procédé de compression selon l'une des revendications 1 à 4,
**caractérisé en ce qu'**il comprend une étape (12) préalable d'optimisation et de simplification du schéma de structure du document consistant à réduire le nombre de niveaux d'imbrications de composants de structure.

6. Procédé de compression selon l'une des revendications 1 à 5,
**caractérisé en ce que** au moins un élément d'informations du document (2) est associé, dans le flux binaire (10) généré, à un code d'élément d'informations qui est repéré de manière à permettre l'accès direct à un élément d'informations compressé particulier dans le flux binaire, sans qu'il soit nécessaire de décompresser les éléments d'informations précédant l'élément à décompresser dans le flux binaire.

7. Procédé de compression selon l'une des revendications 1 à 6,
**caractérisé en ce que** le document compressé généré (10) comprend pour chaque élément d'informations du document structuré (2), un code permettant de déterminer le type d'information associé à l'élément d'informations, et la valeur binaire de l'élément d'informations.

8. Procédé de compression selon l'une des revendications 1 à 7,
**caractérisé en ce que** le schéma de structure (1) du document (2) comprend la définition de sous-types d'au moins un type d'information, et **en ce que** la séquence d'instructions (5) qui est générée pour un composant d'un type (TX) ayant n sous-types ($S_1$, $S_2$, ..., $S_n$) comprend successivement:

- une instruction d'insertion d'un code de sous-type ("flagPoly") représentant un sous-type à appliquer à un élément (X) correspondant dans le document au composant, associée à la taille de ce code en nombre de bits, et
- des instructions de test de la valeur du code de sous-type, chaque instruction de test étant associée à une référence au sous-type ($S_1$, $S_2$, ..., $S_n$) de l'élément (X) correspondant à la valeur du code de sous-type testée, et à une séquence d'instructions qui est générée pour la compression d'un élément (X) associé au sous-type.

9. Procédé de compression selon l'une des revendications 1 à 8,

**caractérisé en ce que** le flux binaire qui est généré pour un composant correspondant dans le document (2) à plusieurs occurrences d'un ensemble d'éléments comportant au moins un élément d'informations, comprend un code de fin prédéfini.

10. Procédé de compression selon l'une des revendications 1 à 9,
**caractérisé en ce que** chaque composant du schéma de structure (1) correspond dans le document (2) à un ensemble d'éléments comprenant au moins un élément d'informations, et est en outre associé à un ensemble de nombres d'occurrences possibles, indiquant le nombre de fois qu'un ensemble d'éléments correspondant à ce composant, peut apparaître dans un élément d'informations de niveau immédiatement supérieur auquel il appartient.

11. Procédé de compression selon la revendication 10,
**caractérisé en ce que** la séquence d'instructions qui est générée pour un composant ayant un nombre d'occurrences égal à 0 ou 1 comprend successivement:

- une instruction d'insertion d'un code de présence ("flagX") sur un bit indiquant la présence ou non dans le document (2) d'un ensemble d'éléments (X) correspondant au composant,
- une instruction de test de la valeur du code de présence, et
- en association avec l'instruction de test, si la valeur du code de présence indique la présence de l'ensemble d'éléments (X) dans le document, une séquence d'instructions qui est générée pour le composant, indépendamment du nombre d'occurrences associé.

12. Procédé de compression selon la revendication 10 ou 11,
**caractérisé en ce que** la séquence d'instructions qui est générée pour un composant ayant un nombre d'occurrences compris entre n et m comprend successivement :

- une instruction d'insertion d'un code de nombre d'occurrences ("loopflagX") indiquant le nombre d'occurrences successives d'un ensemble d'éléments (X) correspondant au composant dans le document compressé, auquel on a retranché le nombre n minimum d'occurrences, associée à la taille de ce code en nombre de bits,
- une instruction de boucle définissant un nombre d'itérations correspondant à la valeur du code de nombre d'occurrences, et
- en association avec l'instruction de boucle, une séquence d'instructions qui est générée pour le composant, indépendamment du nombre d'occurrences associé.

13. Procédé de compression selon la revendication 12,
**caractérisé en ce que** la séquence d'instructions qui est générée pour un composant ayant un nombre d'occurrences compris entre 0 et m comprend en outre :

- une instruction d'insertion d'un code de présence ("shuntflagX") indiquant sur un bit la présence ou non dans le document d'au moins une occurrence de l'ensemble d'éléments (X) correspondant au composant, et
- une instruction de test de la valeur du code de présence, associée à la séquence d'instructions générée pour un nombre d'occurrences compris entre 1 et m du composant, si la valeur du code de présence indique la présence d'au moins un ensemble d'éléments.

14. Procédé de compression selon la revendication 10,
**caractérisé en ce que** la séquence d'instructions qui est générée pour un composant ayant un nombre d'occurrences compris entre n et m comprend successivement :

- une instruction d'insertion d'un code de présence ("flagX") sur un bit d'une occurrence d'un ensemble d'éléments (X) correspondant au composant dans le document (2), associée à la taille de ce code en nombre de bits,
- une instruction de boucle à exécuter tant que le code de présence à insérer indique la présence d'une nouvelle occurrence de l'ensemble d'éléments (X),
- en association avec l'instruction de boucle, une séquence d'instructions qui est générée pour le composant, et une instruction d'insertion d'un nouveau code de présence ("flagX") sur un bit d'une nouvelle occurrence de l'ensemble d'éléments (X) dans le document.

15. Procédé de compression selon l'une des revendications 1 à 14,
**caractérisé en ce que** chaque composant du schéma de structure (1) correspond à un ensemble d'éléments comprenant au moins un élément d'informations, **en ce que** le schéma de structure (1) du document structuré (2)

**EP 1 356 595 B1**

comprend au moins un composant de type séquence de composants ordonnés, dont l'ordre d'apparition dans la séquence définit l'ordre d'apparition dans le document des ensembles d'éléments correspondant aux composants du groupe de type séquence, et **en ce que** la séquence d'instructions qui est générée pour une séquence comprenant n composants (X1, X2, ..., Xn) comprend successivement des séquences d'instructions qui sont générées pour chaque composant de la séquence.

**16.** Procédé de compression selon l'une des revendications 1 à 15,
**caractérisé en ce que** chaque composant du schéma de structure (1) correspond à un ensemble d'éléments comprenant au moins un élément d'informations, **en ce que** le schéma de structure (1) du document à compresser comprend au moins un composant de type groupe de composants alternatifs, chaque composant alternatif correspondant à un ensemble d'éléments d'informations, le composant de type groupe de composants alternatifs correspondant dans le document à l'un des ensembles d'informations correspondant aux composants alternatifs, et **en ce que** la séquence d'instructions qui est générée pour un groupe de composants alternatifs comprenant n composants définissant respectivement n ensembles d'éléments (X1, X2, ..., Xn), comprend successivement :

- une instruction d'insertion d'un code de numéro d'ensemble d'éléments ("flagChoX") désignant l'ensemble d'éléments apparaissant dans le document (2) parmi les n ensembles d'éléments (X1, X2, ..., Xn), associée à la taille en nombre de bits de ce code, et
- des instructions de test de la valeur du code de numéro d'ensemble d'éléments, chaque instruction de test étant associée à une séquence d'instructions qui est générée pour le composant correspondant à l'ensemble d'éléments (Xi) correspondant à la valeur testée du code de numéro d'ensemble d'éléments.

**17.** Procédé de compression selon l'une des revendications 1 à 16,
**caractérisé en ce que** chaque composant du schéma de structure (1) correspond à un ensemble d'éléments comprenant au moins un élément d'informations, **en ce que** le schéma de structure (1) du document à compresser comprend au moins un groupe de type non ordonné de composants, chaque composant du groupe non ordonné correspondant à un ensemble d'éléments et le groupe de type groupe non ordonné correspondant dans le document à un groupe rassemblant dans un ordre quelconque tous les ensembles d'éléments correspondant aux composants du groupe de type non ordonné, et **en ce que** la séquence d'instructions qui est générée pour un groupe de type non ordonné comportant n composants correspondant dans le document respectivement à n ensembles d'éléments (X1, X2,..., Xn), comprend successivement :

- une instruction d'insertion d'un code ("flagChoX") de numéro d'ensemble d'éléments (Xi) et désignant le prochain ensemble d'éléments apparaissant dans le document (2), associée à la taille en nombre de bits de ce code, et
- des instructions de test de la valeur du code de numéro d'ensemble d'éléments, chaque instruction de test étant associée à une séquence d'instructions qui est générée pour le composant correspondant à l'ensemble d'éléments (Xi) correspondant à la valeur de code de numéro d'ensemble d'éléments testée, et une séquence d'instructions qui est générée pour un groupe de type non ordonné comprenant tous les composants (X1, ..., Xn) du groupe non ordonné sauf le composant correspondant à l'ensemble d'éléments (Xi).

**18.** Procédé de décompression d'un document structuré comprenant des éléments d'informations imbriqués les uns dans les autres et associés chacun à un type d'information, le document structuré (2) étant associé à au moins un schéma de structure (1 ; 31, 39, 43) définissant une structure arborescente du document et comprenant des composants de structure (a3, a4, X, Y, a1, a5, a1, a2, A, B, 32, 33, 34, 40, 44, 45, 46) imbriqués les uns dans les autres, chaque type d'information du document étant défini par un composant du schéma,
**caractérisé en ce qu'**il comprend des étapes consistant à :

- analyser (11) le schéma de structure (1) du document générer, pour chaque composant du schéma de structure, une séquence d'instructions exécutables (5), comportant des instructions de lecture dans un flux binaire constituant le document compressé (10), de codes de contrôle et de valeurs compressées d'éléments d'informations ou de codes d'appel de séquences d'instructions de composant, et des instructions de contrôle du déroulement de l'exécution de la séquence en fonction des valeurs des codes de contrôle, l'exécution des séquences d'instructions sur le document compressé (10) permettant de reconstituer un document (2') au format du document (2) d'origine et ayant une structure au moins équivalente
- exécuter (14') sur le flux binaire constituant le document à décompresser (10) les séquences d'instructions générées pour obtenir un document structuré (2') au format du document structuré (2) d'origine et ayant une structure au moins équivalente.

**19.** Procédé de décompression selon la revendication 18,
**caractérisé en ce que**, le document structuré (2) comprenant des éléments de base non décomposés en sous-éléments, au moins un type d'information des éléments de base est associé à un algorithme de décompression (16') adapté au type d'information, le procédé comprenant, durant l'exécution des séquences d'instructions (5) sur le flux binaire constituant le document compressé (10), la détection dans le flux binaire d'un code binaire d'élément d'informations correspondant audit type d'information, et l'application de l'algorithme de décompression à ce code binaire.

**20.** Procédé de décompression selon la revendication 18 ou 19,
**caractérisé en ce qu'**il comprend une étape de compilation (17) des séquences d'instructions (5) obtenues pour chaque composant dudit schéma de structure (1), pour obtenir un programme binaire de décodage (6) dédié audit schéma de structure, et directement exécutable ou interprétable par un calculateur pour décompresser un document (10) ayant ce schéma de structure.

**21.** Procédé de décompression selon l'une des revendications 18 à 20,
**caractérisé en ce qu'**il comprend une étape préalable de normalisation (12) du schéma de structure (5) du document, de manière à obtenir un ordre unique prédéfmi des composants du schéma,

**22.** Procédé de décompression selon l'une des revendications 18 à 21,
**caractérisé en ce qu'**il comprend une étape (12) préalable d'optimisation et de simplification du schéma de structure du document consistant à réduire le nombre de niveaux hiérarchiques de groupes de composants de structure.

**23.** Procédé de décompression selon l'une des revendications 18 à 22,
**caractérisé en ce que** au moins un code d'élément d'informations est repéré dans le flux binaire du document compressé (10), de manière à permettre l'accès direct à cet élément d'informations, sans qu'il soit nécessaire de décompresser les éléments d'informations précédant cet élément dans le flux binaire.

**24.** Procédé de décompression selon l'une des revendications 18 à 23,
**caractérisé en ce que** le document compressé (10) comprend pour chaque élément d'informations du document d'origine, un code permettant de déterminer le type d'information associé à l'élément d'informations et la valeur binaire de l'élément d'informations compressé.

**25.** Procédé de décompression selon l'une des revendications 18 à 24,
**caractérisé en ce que** le schéma de structure (1) du document à décompresser (10) comprend la définition de sous-types d'au moins un type d'information (TX), et **en ce que** la séquence d'instructions (5) qui est générée pour un composant d'un type (TX) ayant n sous-types ($S_1$, $S_2$, ..., $S_n$) comprend successivement :

- une instruction de lecture d'un code de sous-type ("flagPoly") représentant un numéro du sous-type à appliquer à un élément (X) correspondant dans le document au composant, associée à la taille de ce code en nombre de bits, et
- des instructions de test de la valeur du code de sous-type, chaque instruction de test étant associée à une référence au sous-type ($S_1$, $S_2$, ..., $S_n$) de l'élément (X) correspondant à la valeur du code de sous-type testée, et à une séquence d'instructions qui est générée pour la décompression d'un élément (X) associé au sous-type.

**26.** Procédé de décompression selon l'une des revendications 18 à 25,
**caractérisé en ce que** dans le flux binaire du document compressé (10), la fin d'un groupe de plusieurs occurrences d'un ensemble d'éléments comportant au moins un élément d'informations et correspondant à un composant du schéma (1), est marquée par un code binaire déterminé.

**27.** Procédé de décompression selon l'une des revendications 18 à 26,
**caractérisé en ce que** chaque composant du schéma de structure (1) correspond dans le flux binaire du document (10) à un ensemble d'éléments comprenant au moins un élément d'informations, et est en outre associé à un ensemble de nombres d'occurrences possibles, indiquant le nombre de fois qu'un ensemble d'éléments correspondant à ce composant de structure, peut apparaître dans l'élément d'informations de niveau immédiatement supérieur auquel il appartient.

**28.** Procédé de décompression selon la revendication 27,
**caractérisé en ce que** la séquence d'instructions qui est générée pour un composant ayant un nombre d'occurrences égal à 0 ou 1 comprend successivement :

- une instruction de lecture d'un code de présence ("flagX") sur un bit indiquant la présence ou non dans le document compressé d'un ensemble d'éléments (X) correspondant au composant,
- une instruction de test de la valeur du code de présence, et
- en association avec l'instruction de test, si la valeur du code de présence indique la présence de l'ensemble d'éléments (X) dans le document compressé, une séquence d'instructions qui est générée pour le composant, indépendamment du nombre d'occurrences associé.

**29.** Procédé de décompression selon la revendication 27 ou 28, **caractérisé en ce que** la séquence d'instructions qui est générée pour un composant ayant un nombre d'occurrences compris entre n et m comprend successivement :

- une instruction de lecture d'un code de nombre d'occurrences ("loopflagX") indiquant le nombre d'occurrences successives dans le document compressé d'un ensemble d'éléments (X) correspondant au composant, auquel on a retranché le nombre n minimum d'occurrences, associée à la taille de ce code en nombre de bits,
- une instruction de boucle définissant un nombre d'itérations correspondant à la valeur du code de nombre d'occurrences, et
- en association avec l'instruction de boucle, une séquence d'instructions qui est générée pour le composant, indépendamment du nombre d'occurrences associé.

**30.** Procédé de décompression selon la revendication 29, **caractérisé en ce que** la séquence d'instructions qui est générée pour un composant ayant un nombre d'occurrences compris entre 0 et m comprend en outre :

- une instruction de lecture d'un code de présence ("shuntflagX") indiquant sur un bit la présence ou non dans le document compressé d'au moins une occurrence d'un ensemble d'éléments (X) correspondant au composant, et
- une instruction de test de la valeur du code de présence, associée à la séquence d'instructions générée pour un nombre d'occurrences compris entre 1 et m du composant, si la valeur du code de présence indique la présence d'au moins un ensemble d'éléments.

**31.** Procédé de décompression selon la revendication 27, **caractérisé en ce que** la séquence d'instructions qui est générée pour un composant ayant un nombre d'occurrences compris entre n et m comprend successivement :

- une instruction de lecture d'un code de présence ("flagX") sur un bit d'une occurrence d'un ensemble d'éléments (X) correspondant au composant dans le document compressé (10), associée à la taille de ce code en nombre de bits,
- une instruction de boucle à exécuter tant que le code de présence lu dans le flux binaire du document compressé indique la présence d'une nouvelle occurrence de l'ensemble d'éléments (X),
- en association avec l'instruction de boucle, une séquence d'instructions qui est générée pour le composant, et une instruction d'insertion d'un nouveau code de présence ("flagX") sur un bit d'une nouvelle occurrence de l'ensemble d'éléments (X) dans le document compressé (10).

**32.** Procédé de décompression selon l'une des revendications 18 à 31, **caractérisé en ce que** chaque composant du schéma de structure (1) correspond à un ensemble d'éléments comprenant au moins un élément d'informations, **en ce que** le schéma de structure (1) du document compressé (10) comprend au moins un composant de type séquence de composants ordonnés, dont l'ordre d'apparition dans la séquence définit l'ordre d'apparition dans le document des ensembles d'éléments correspondant aux composants du groupe de type séquence, et **en ce que** la séquence d'instructions qui est générée pour une séquence comprenant n composants (X1, X2, ..., Xn) comprend successivement des séquences d'instructions qui sont générées pour chaque composant de la séquence.

**33.** Procédé de décompression selon l'une des revendications 18 à 32, **caractérisé en ce que** chaque composant du schéma de structure (1) correspond à un ensemble d'éléments comprenant au moins un élément d'informations, **en ce que** le schéma de structure (1) du document à décompresser comprend au moins un composant de type groupe de composants alternatifs, chaque composant alternatif correspondant à un ensemble d'éléments d'informations, le composant de type groupe de composants alternatifs correspondant dans le document à l'un des ensembles d'informations correspondant aux composants alternatifs, et **en ce que** la séquence d'instructions qui est générée pour un groupe de composants alternatifs comprenant n composants définissant respectivement n ensembles d'éléments (X1, X2, ..., Xn), comprend successivement :

- une instruction de lecture d'un code de numéro d'ensemble d'éléments ("flagChoX") désignant l'ensemble d'éléments apparaissant dans le document (10) parmi les n ensembles d'éléments (X1, X2, ..., Xn), associée à la taille en nombre de bits de ce code, et
- des instructions de test de la valeur du code de numéro d'ensemble d'éléments, chaque instruction de test étant associée à une séquence d'instructions qui est générée pour le composant correspondant à l'ensemble d'éléments (Xi) correspondant à la valeur testée du code de numéro d'ensemble d'éléments.

34. Procédé de décompression selon l'une des revendications 18 à 33,
**caractérisé en ce que** chaque composant du schéma de structure (1) correspond à un ensemble d'éléments comprenant au moins un élément d'informations, **en ce que** le schéma de structure (1) du document à décompresser comprend au moins un groupe de type non ordonné de composants, chaque composant du groupe non ordonné correspondant à un ensemble d'éléments et le groupe de type groupe non ordonné correspondant dans le document à un groupe rassemblant dans un ordre quelconque tous les ensembles d'éléments correspondant aux composants du groupe de type non ordonné, et **en ce que** la séquence d'instructions qui est générée pour un groupe de type non ordonné comportant n composants correspondant dans le document respectivement à n ensembles d'éléments (X1, X2, ..., Xn), comprend successivement :

- une instruction de lecture d'un code de numéro d'ensemble d'éléments (Xi) et désignant le prochain ensemble d'éléments apparaissant dans le document (10), associée à la taille en nombre de bits de ce code, et
- des instructions de test de la valeur du code de numéro d'ensemble d'éléments, chaque instruction de test étant associée à une séquence d'instructions qui est générée pour le composant correspondant à l'ensemble d'éléments (Xi) correspondant à la valeur de code de numéro d'ensemble d'éléments testée, et une séquence d'instructions qui est générée pour un groupe de type non ordonné comprenant tous les composants (X1, ..., Xn) du groupe non ordonné sauf le composant correspondant à l'ensemble d'éléments (Xi).

## Claims

1. Method for compressing a structured document comprising information elements nested in each other and each associated with an information type, the structured document (2) being associated with at least one structure diagram (1; 31, 39, 43) defining a tree document structure and comprising structure components (a3, a4, X, Y, a1, a5, a1, a2, A, B, 32, 33, 34, 40, 44, 45, 46) nested in each other, each type of document information being defined by a component in the diagram, **characterised in that** it comprises steps consisting in:

- analysing (11) the document structure diagram (1), generating a sequence of executable instructions (5) for each component of the structure diagram, this sequence comprising instructions for inserting into a bit stream control codes and compressed values of information elements or component instruction sequence call codes, and instructions for controlling the execution of the sequence as a function of control code values, execution of the instruction sequences on the structured document (2) compressing the structured document (2) into a bit stream (10) containing compressed values of the information elements in the document,
- executing (14) the generated instruction sequences on the structured document (2) in order to obtain a bit stream (10) containing the compressed values of the document information elements.

2. Compression method according to claim 1, **characterised in that**, since the document comprises basic elements not broken down into sub-elements, at least one type of basic element information is associated in advance with a compression algorithm (16) adapted to the type of information, the method comprising application of the compression algorithm (16) to the value of each information element with an information type associated with the said algorithm, during execution of the instruction sequences (5).

3. Compression method according to claims 1 or 2, **characterised in that** it comprises a step of compilation (17) of instruction sequences (5) obtained for each component of the said structure diagram to obtain a binary encoding program (6) dedicated to the said structure diagram and directly executable or interpretable by a computer to compress a document (2) with the structure diagram (1).

4. Compression method according to one of claims 1 to 3, **characterised in that** it comprises a prior step of normalisation (12) of the document structure diagram (5), so as to obtain a single predefined order of components in the diagram.

5. Compression method according to one of claims 1 to 4, **characterised in that** it comprises a prior step (12) for optimisation and simplification of the document structure diagram consisting in reducing the number of structure component nesting levels.

6. Compression method according to one of claims 1 to 5, **characterised in that** at least one information element in the document (2) is associated with an information element code in the bit stream generated (10), which is marked so as to enable direct access to a particular compressed information element in the bit stream, without it being necessary to decompress information elements preceding the element to be decompressed in the bit stream.

7. Compression method according to one of claims 1 to 6, **characterised in that** the compressed document generated (10) comprises a code for each information element in the structured document (2), used to determine the type of information associated with the information element and the binary value of the information element.

8. Compression method according to one of claims 1 to 7, **characterised in that** the structure diagram (1) of the document (2) comprises the definition of sub-types of at least one type of information, and **in that** the instruction sequence (5) generated for a component of a type (TX) with n sub-types ($S_1$, $S_2$, ..., $S_n$) successively comprises:

   - an instruction to insert a sub-type code ("flagPoly") representing a sub-type to be applied to an element (X) corresponding to the component in the document, associated with the size of this code as a number of bits, and
   - instructions to test the value of the sub-type code, each test instruction being associated with a reference to the sub-type ($S_1$, $S_2$, ... , $S_n$) of the element (X) corresponding to the value of the sub-type code tested, and an instruction sequence generated for compression of an element (X) associated with the sub-type.

9. Compression method according to one of claims 1 to 8, **characterised in that** the bit stream generated for a component corresponding to several occurrences of a set of elements comprising at least one information element in the document (2), comprises a predefined end code.

10. Compression method according to one of claims 1 to 9, **characterised in that** each component of the structure diagram (1) corresponds to a set of elements in the document (2) comprising at least one information element, and is also associated with a set of numbers of possible occurrences, indicating the number of times that a set of elements corresponding to this component may appear in an information element at a level immediately above that to which it belongs.

11. Compression method according to claim 10, **characterised in that** the instruction sequence generated for a component with a number of occurrences equal to 0 or 1 successively comprises:

   - an instruction to insert a presence code ("flagX") on one bit indicating whether or not a set of elements (X) corresponding to the component is present in the document (2),
   - an instruction to test the value of the presence code, and
   - in association with the test instruction, if the value of the presence code indicates the presence of the set of element (X) in the document, an instruction sequence generated for the component, independently of the associated number of occurrences.

12. Compression method according to claim 10 or 11, **characterised in that** the instruction sequence generated for a component with a number of occurrences between n and m includes the following successively:

   - an instruction to insert a number of occurrences code ("loopflagX") indicating the number of successive occurrences of a set of elements (X) corresponding to the component in the compressed document, minus the minimum number n of occurrences, associated with the size of this code as a number of bits,
   - a loop instruction defining a number of iterations corresponding to the value of the number of occurrences codes, and
   - in association with the loop instruction, an instruction sequence generated for the component independently of the associated number of occurrences.

**13.** Compression method according to claim 12, **characterised in that** the instruction sequence generated for a component with a number of occurrences between 0 and m also comprises:

- an instruction to insert a presence code ("shuntflagX") indicating whether or not there is at least one occurrence of the set of elements (X) corresponding to the component in the document, and
- an instruction to test the value of the presence code associated with the instruction sequence generated for a number of occurrences of the component between 1 and m, if the value of the presence code indicates that at least one set of elements is present.

**14.** Compression method according to claim 10, **characterised in that** the instruction sequence generated for a component with a number of occurrences between n and m successively includes:

- an instruction to insert a single-bit presence code ("flagX") indicating an occurrence of a set of elements (X) corresponding to the component in the document (2), associated with the size of this code as a number of bits,
- a loop instruction to be executed as long as the presence code to be inserted indicates that a new occurrence of the elements (X) set is present,
- in association with the loop instruction, an instruction sequence generated for the component, and an instruction to insert a new single-bit presence code ("flagX") indicating a new occurrence of the set of elements (X) in the document.

**15.** Compression method according to one of claims 1 to 14, **characterised in that** each component in the structure diagram (1) corresponds to a set of elements comprising at least one information element, and **in that** the structure diagram (1) of the structured document (2) comprises at least one sequence type component of ordered components, in which the order of appearance in the sequence defines the order of appearance in the document of sets of element corresponding to components of the sequence type group, and **in that** the instruction sequence generated for a sequence comprising n components (X1, X2, ..., Xn) comprises instruction sequences generated successively for each component in the sequence.

**16.** Compression method according to one of claims 1 to 15, **characterised in that** each component in the structure diagram (1) corresponds to a set of elements comprising at least one information element, **in that** the structure diagram (1) of the document to be compressed comprises at least one component of the choice components group type, each choice component corresponding to a set of information elements, the component of the choice components group type corresponding in the document to one of the sets of information corresponding to choice components, and **in that** the instruction sequence generated for a group of choice components comprising n components respectively defining n sets of elements (X1, X2, ... , Xn), successively comprises:

- an instruction to insert a set of elements number code ("flagChoX") denoting which set of elements among the n element sets (X1, X2, ... , Xn) appears in the document (2), associated with the size of this code as a number of bits, and
- instructions to test the value of the set of elements number code, each test instruction being associated with an instruction sequence generated for the component corresponding to the set of elements (Xi) corresponding to the tested value of the set of elements number code.

**17.** Compression method according to one of claims 1 to 16, **characterised in that** each component of the structure diagram (1) corresponds to a set of elements comprising at least one information element, **in that** the structure diagram (1) of the document to be compressed comprises at least one unordered components group type, each component in the unordered group corresponding to a set of elements and the group of the unordered group type corresponding in the document to a group containing all sets of element corresponding to components of the unordered type group, in an arbitrary order, and **in that** the instruction sequence generated for an unordered type group comprising n components corresponding to n element sets (X1, X2, ..., Xn) in the document, successively comprises:

- an instruction to insert a set of elements (Xi) number code ("flagChoX") and denoting the next set of elements appearing in the document (2) associated with the size of this code as a number of bits, and
- instructions to test the value of the set of elements number code, each test instruction being associated with an instruction sequence generated for the component corresponding to the set of elements (Xi) corresponding to the tested value of the set of elements number code, and an instruction sequence generated for an unordered type group comprising all components (X1, ... , Xn) of the unordered group except for the component corresponding to the set of elements (Xi).

**18.** Method for decompressing a structured document comprising information elements nested in each other and each associated with an information type, the structured document (2) being associated with at least one structure diagram (1; 31, 39, 43) defining a tree document structure and comprising structure components (a3, a4, X, Y, a1, a5, a1, a2, A, B, 32, 33, 34, 40, 44, 45, 46) nested in each other, each type of document information being defined by a component of the diagram, **characterised in that** it comprises steps consisting in:

- analysing (11) the document structure diagram (1), generating a sequence of executable instructions (5) for each component of the structure diagram, this sequence comprising instructions for reading control codes and compressed values of information elements or component instruction sequence call codes in a bit stream forming the compressed document (10), and instructions for controlling the execution of the sequence as a function of the control code values, the execution of instruction sequences on the compressed document (10) making it possible to restore a document (2') in the same format as the original document (2) and with at least an equivalent structure.
- executing (14') the generated instruction sequences on the bit stream comprising the document to be decompressed (10) in order to obtain a structured document (2') in the format of the original structured document (2) and with at least an equivalent structure.

**19.** Decompression method according to claim 18, **characterised in that**, since the structured document (2) comprises basic elements not broken down into sub-elements, at least one basic elements information type is associated with a decompression algorithm (16') adapted to the information type, the method comprising detection of an information element binary code corresponding to said information type and application of the decompression algorithm to this binary code in the bit stream during execution of instruction sequences (5) in the bit stream forming the compressed document (10).

**20.** Decompression method according to one of claims 18 or 19, **characterised in that** it comprises a step of compiling (17) instruction sequences (5) obtained for each component of said structure diagram (1), to obtain a binary decoding program (6) dedicated to the said structure diagram, and directly executable or interpretable by a computer to decompress a document (10) with this structure diagram.

**21.** Decompression method according to one of claims 18 to 20, **characterised in that** it comprises a prior step for normalisation (12) of the document structure diagram (5), so as to obtain a single predefined order of the components of the diagram.

**22.** Decompression method according to one of claims 18 to 21, **characterised in that** it comprises a prior step (12) for optimisation and simplification of the document structure diagram consisting in reducing the number of hierarchical levels of structure component groups.

**23.** Decompression method according to one of claims 18 to 22, **characterised in that** at least one information element code is identified in the bit stream of the compressed document (10), so as to enable direct access to this information element, without it being necessary to decompress information elements preceding this element in the bit stream.

**24.** Decompression method according to one of claims 18 to 23, **characterised in that** the compressed document (10) comprises a code for each information element in the original document, to determine the information type associated with the information element and the binary value of the compressed information element.

**25.** Decompression method according to one of claims 18 to 24, **characterised in that** the structure diagram (1) of the document to be decompressed (10) comprises the definition of sub-types of at least one information type (TX), and **in that** the instruction sequence (5) generated for a component of a type (TX) with n sub-types ($S_1$, $S_2$, ... , $S_n$) successively comprises:

- an instruction to read a sub-type code ("flagPoly") representing a number of the sub-type to be applied to an element (X) corresponding to the component in the document, associated with the size of this code as a number of bits, and
- instructions to test the value of the sub-type code, each test instruction being associated with a reference to the sub-type ($S_1$, $S_2$, ..., $S_n$) of the element (X) corresponding to the value of the sub-type code tested, and an instruction sequence generated for decompression of an element (X) associated with the sub-type.

**26.** Decompression method according to one of claims 18 to 25, **characterised in that** the end of a group of several occurrences of a set of elements comprising at least one information element and corresponding to a component of the diagram (1), is marked by a determined binary code in the bit stream of the compressed document (10).

27. Decompression method according to one of claims 18 to 26, **characterised in that** each component in the structure diagram (1) corresponds to a set of elements in the bit stream of the document (10), comprising at least one information element, and is also associated with a set of possible numbers of occurrences, indicating the number of times that a set of elements corresponding to this structure component can appear in the information element at a level immediately above that to which it belongs.

28. Decompression method according to claim 27, **characterised in that** the instruction sequence generated for a component with a number of occurrences equal to 0 or 1 successively comprises:

  - an instruction to read a single-bit presence code ("flagX") indicating whether or not a set of elements (X) corresponding to the component is present in the compressed document,
  - an instruction to test the value of the presence code, and
  - in association with the test instruction, if the value of the presence code indicates that the set of elements (X) is present in the compressed document, an instruction sequence generated for the component independently of the associated number of occurrences.

29. Decompression method according to claim 27 or 28, **characterised in that** the instruction sequence generated for a component with a number of occurrences between n and m successively comprises:

  - an instruction to read a number of occurrences code ("loopflagX") indicating the number of successive occurrences in the compressed document of a set of elements (X) corresponding to the component, minus the minimum number n of occurrences associated with the size of this code as a number of bits,
  - a loop instruction defining a number of iterations corresponding to the value of the number of occurrences code, and
  - in association with the loop instruction, an instruction sequence generated for the component, independently of the associated number of occurrences.

30. Decompression method according to claim 29, **characterised in that** the instruction sequence generated for a component with a number of occurrences between 0 and m also comprises:

  - an instruction to read a single-bit presence code ("shuntflagX") indicating whether or not there is at least one occurrence of a set of elements (X) corresponding to the component in the compressed document, and
  - an instruction to test the value of the presence code, associated with the instruction sequence generated for a number of occurrences of the component between 1 and m, if the value of the presence code indicates that there is at least one set of elements present.

31. Decompression method according to claim 27, **characterised in that** the instruction sequence generated for a component with a number of occurrences between n and m successively comprises:

  - an instruction to read a single-bit presence code ("flagX") indicating whether or not there is an occurrence of a set of elements (X) corresponding to the component in the compressed document (10), associated with the size of this code as a number of bits,
  - a loop instruction to be executed as long as the presence code read in the bit stream of the compressed document indicates that there is a new occurrence of the set of elements (X),
  - in association with the loop instruction, an instruction sequence generated for the component, and an instruction to insert a new single-bit presence code ("flagX") indicating whether or not there is a new occurrence of the set of elements (X) in the compressed document (10).

32. Decompression method according to one of claims 18 to 31, **characterised in that** each component of the structure diagram (1) corresponds to a set of elements comprising at least one information element, **in that** the structure diagram (1) of the compressed document (10) comprises at least one ordered components sequence type component, for which the order of appearance in the sequence defines the order of appearance of sets of elements in the document corresponding to components of the sequence type group, and **in that** the instruction sequence generated for a sequence comprising n components (X1, X2, ... , Xn) comprises instruction sequences generated for each component in the sequence successively.

**33.** Decompression method according to one of claims 18 to 32, **characterised in that** each component in the structure diagram (1) corresponds to a set of elements comprising at least one information element, **in that** the structure diagram (1) of the document to be decompressed comprises at least one component of the choice components group type, each choice component corresponding to a set of information elements, the component of the choice components group type in the document corresponding to one of the sets of information corresponding to the choice components, and **in that** the instruction sequence generated for an choice components group comprising n components (X1, X2, ... , Xn) defining n sets of elements respectively, successively comprises:

- an instruction to read a set of elements number code ("flagChoX") denoting the set of elements appearing in the document (10) among the n sets of elements (X1, X2, ... , Xn), associated with the size of this code as a number of bits, and
- instructions to test the value of the set of elements number code, each test instruction being associated with an instruction sequence generated for the component corresponding to the set of elements (Xi) corresponding to the tested value of the set of elements number code.

**34.** Decompression method according to one of claims 18 to 33, **characterised in that** each component in the structure diagram (1) corresponds to a set of elements comprising at least one information element, **in that** the structure diagram (1) of the document to be decompressed comprises at least one component of the unordered type group, each component in the unordered group corresponding to a set of elements and the group of the unordered group type corresponding to a group in the document, containing all sets of elements corresponding to components of the unordered type group, in an arbitrary order, and **in that** the instruction sequence generated for an unordered type group comprising n components corresponding to n sets of elements (X1, X2, ... , Xn) in the document, successively comprises:

- an instruction to read a number code for a set of elements (Xi) and denoting the next set of elements appearing in the document (10), associated with the size of this code as a number of bits, and
- instructions to test the value of the set of elements number code, each test instruction being associated with an instruction sequence generated for the component corresponding to the set of elements (Xi) corresponding to the tested value of the set of elements number code, and an instruction sequence generated for an unordered type group comprising all components (X1, ..., Xn) of the unordered group except for the component corresponding to the set of elements (Xi).

**Patentansprüche**

**1.** Verfahren zur Kompression eines strukturierten Dokumentes, umfassend Informationselemente, die ineinander verschachtelte und jeweils mit einer Informationsart verbunden sind, wobei das strukturierte Dokument (2) mit mindestens einem Strukturschema (1; 31, 39, 43) verbunden ist, das eine Baumstruktur des Dokumentes definiert und ineinander verschachtelte Strukturkomponenten (a3, a4, X, Y, a1, a5, a1, a2, A, B, 32, 33, 34, 40, 44, 45, 46) umfasst, wobei jede Informationsart des Dokumentes durch eine Komponente des Schemas definiert ist, **dadurch gekennzeichnet, dass** es Schritte aufweist, die Folgendes umfassen:

- Analysieren (11) des Strukturschemas (1) des Dokumentes, Erzeugung für jede Komponente des Strukturschemas eines ausführbaren Steuerungsablaufs (5) mit Anweisungen zur Einfügung in einen binären Fluss, Kontrollcodes und komprimierte Werte von Informationselementen oder Aufrufcodes von Steuerungsabläufen der Komponente und Kontrollanweisungen des Ablaufs der Durchführung der Sequenz je nach den Werten der Kontrollcodes, die Durchführung der Steuerungsabläufe auf dem strukturierten Dokument (2), die es ermöglicht, das strukturierte Dokument(2) in einen binären Fluss (10) zu komprimieren, der komprimierte Werte der Informationselemente des Dokumentes umfasst, aufweist
- Durchführen (14) der erzeugten Steuerungsabläufe auf dem strukturierten Dokument (2), um einen binären Fluss (10) zu erhalten, der die komprimierten Werte der Informationselemente des Dokumentes umfasst.

**2.** Verfahren zur Kompression nach Anspruch 1, **dadurch gekennzeichnet, dass**, da das Dokument nicht in Unterelemente zerlegte Grundelemente umfasst, mindestens eine Informationsart der Grundelemente vorherig mit einem Kompressionsalgorithmus (16) verbunden ist, der der Informationsart angepasst ist, wobei das Verfahren während der Durchführung der Steuerungsabläufe (5) die Anwendung des Kompressionsalgorithmus (16) auf den Wert jedes Informationselementes mit einer mit dem Algorithmus verbundenen Informationsart umfasst.

3. Verfahren zur Kompression nach Anspruch 1 oder 2, **dadurch gekennzeichnet, dass** es einen Schritt des Kompilierens (17) der Steuerungsabläufe (5) umfasst, die für jede Komponente des Strukturschemas (5) erhalten werden, um ein binäres Codierungsprogramm (6) zu erhalten, das dem Strukturschema zugewiesen und direkt von einem Rechner durchführ- oder interpretierbar ist, um ein Dokument (2) mit dem Strukturschema (1) zu komprimieren.

4. Verfahren zur Kompression nach einem der Ansprüche 1 bis 3, **dadurch gekennzeichnet, dass** es einen vorherigen Schritt des Normalisierens (12) des Strukturschemas (5) des Dokumentes umfasst, um eine einmalige vordefinierte Reihenfolge der Komponenten des Schemas zu erhalten.

5. Verfahren zur Kompression nach einem der Ansprüche 1 bis 4, **dadurch gekennzeichnet, dass** es einen vorherigen Schritt (12) des Optimierens und des Vereinfachens des Strukturschemas des Dokumentes umfasst, der darin besteht, die Anzahl der Verschachtelungsebenen der Strukturkomponenten zu reduzieren.

6. Verfahren zur Kompression nach einem der Ansprüche 1 bis 5, **dadurch gekennzeichnet, dass** mindestens ein Informationselement des Dokumentes (2) in dem erzeugten binären Fluss (10) mit einem Informationselementcode verbunden ist, der so markiert ist, dass er den direkten Zugang zu einem bestimmten komprimierten Informationselement im binären Fluss ermöglicht, ohne dass es erforderlich ist, die Informationselemente zu dekomprimieren, die dem zu dekomprimierenden Element im binären Fluss vorausgehen.

7. Verfahren zur Kompression nach einem der Ansprüche 1 bis 6, **dadurch gekennzeichnet, dass** das erzeugte komprimierte Dokument (10) für jedes Informationselement des strukturierten Dokumentes (2) einen Code umfasst, der es ermöglicht, die Art der mit dem Informationselement verbundenen Information sowie den binären Wert des Informationselementes zu bestimmen.

8. Verfahren zur Kompression nach einem der Ansprüche 1 bis 7, **dadurch gekennzeichnet, dass** das Strukturschema (1) des Dokumentes (2) die Definition von Unterarten mindestens einer Informationsart umfasst, und **dadurch**, dass der Steuerungsablauf (5), der für eine Komponente einer Art (TX) mit n Unterarten ($S_1$, $S_2$, ..., $S_n$) erzeugt wird, nacheinander umfasst:

   - eine Anweisung zur Einfügung eines Unterartcodes ("flagPoly"), der eine Unterart darstellt, die auf ein Element (x) anzuwenden ist, das im Dokument der Komponente entspricht, verbunden mit der Größe dieses Codes durch die Bit-Anzahl, und
   - Anweisungen zum Test des Codewertes der Unterart, wobei jede Testanweisung mit einer Referenz auf die Unterart ($S_1$, $S_2$, ..., $S_n$) des Elementes (X) verbunden ist, das dem Codewert der getestetert Unterart entspricht, sowie mit einem Steuerungsablauf, der für die Kompression eines mit der Unterart verbundenen Elementes (X) erzeugt wird.

9. Verfahren zur Kompression nach einem der Ansprüche 1 bis 8, **dadurch gekennzeichnet, dass** der binäre Fluss, der für eine Komponente erzeugt wird, die im Dokument (2) einem mehrmaligen Vorkommen einer Elementmenge entspricht, die mindestens ein Informationselement umfasst, einen vordefinierten Schlusscode aufweist.

10. Verfahren zur Kompression nach einem der Ansprüche 1 bis 9, **dadurch gekennzeichnet, dass** jede Komponente des Strukturschemas (1) im Dokument (2) einer Elementmenge entspricht, die mindestens ein Informationselement umfasst, und außerdem mit einer Gesamtanzahl möglicher Vorkommen verbunden ist, wobei die Häufigkeit angegeben wird, mit der eine Elementmenge, die dieser Komponente entspricht, in einem Informationselement der Ebene erscheinen kann, die unmittelbar über derjenigen liegt, zu der sie gehört.

11. Verfahren zur Kompression nach Anspruch 10, **dadurch gekennzeichnet, dass** der Steuerungsablauf, der für eine Komponente mit einer Anzahl des Vorkommens gleich 0 oder 1 erzeugt wird, nacheinander umfasst:

   - eine Anweisung zur Einfügung eines Anwesenheitscodes ("flagX") in ein Bit, das die An- oder die Abwesenheit einer Elementmenge (X), die der Komponente entspricht, im Dokument (2) angibt.
   - eine Anweisung zum Test des Wertes des Anwesenheitscodes und
   - in Verbindung mit der Testanweisung, wenn der Wert des Anwesenheitscodes die Anwesenheit der Elementgruppe (X) im Dokument angibt, ein Steuerungsablauf, der für die Komponente unabhängig von der Anzahl der verbundenen Vorkommnisse erzeugt wird.

12. Verfahren zur Kompression nach Anspruch 10 oder 11, **dadurch gekennzeichnet, dass** der Steuerungsablauf, der für eine Komponente mit einer Anzahl des Vorkommens zwischen n und m erzeugt wird, nacheinander umfasst:

- eine Anweisung zur Einfügung eines Codes der Anzahl des Vorkommens ("loopflagX"), der die Anzahl des aufeinander folgenden Vorkommens einer Elementmenge (X) angibt, die der Komponente im komprimierten Dokument entspricht, von der die Anzahl n des minimalen Vorkommens abgezogen wurde, verbunden mit der Größe dieses Codes durch die Bit-Anzahl.
- eine Schleifenanweisung, die die Anzahl der Widerholungen definiert, die dem Wert des Codes der Anzahl des Vorkommens entspricht und
- in Verbindung mit der Schleifenanweisung, ein Steuerungsablauf, der für die Komponente unabhängig von der Anzahl des verbundenen Vorkommens erzeugt wird.

**13.** Verfahren zur Kompression nach Anspruch 12, **dadurch gekennzeichnet, dass** der Steuerungsablauf, der für eine Komponente mit einer Anzahl des Vorkommens zwischen 0 und m erzeugt wird, außerdem aufweist:

- eine Anweisung zur Einfügung eines Anwesenheitscodes ("shuntflagX"), die auf einem Bit die An- oder Abwesenheit im Dokument mindestens eines Vorkommens der Elementmenge (X) entsprechend der Komponente angibt, und
- eine Anweisung zum Test des Wertes des Anwesenheitscodes, verbunden mit dem Steuerungsablauf, der für eine Anzahl des Vorkommens zwischen 1 und m der Komponente erzeugt wurde, wenn der Wert des Anwesenheitscodes die Anwesenheit von mindestens einer Elementmenge angibt.

**14.** Verfahren zur Kompression nach Anspruch 10, **dadurch gekennzeichnet, dass** der Steuerungsablauf, der für eine Komponente mit einer Anzahl des Vorkommens zwischen n und m erzeugt wird, nacheinander umfasst:

- eine Anweisung zur Einfügung eines Anwesenheitscodes ("flagX") auf einem Bit eines Vorkommens einer Elementmenge (X), der der Komponente im Dokument (2) entspricht, verbunden mit der Größe dieses Codes nach der Bit-Anzahl
- eine Schleifenanweisung, die durchgeführt werden muss, sobald der einzufügende Anwesenheitscode die Anwesenheit eines neuen Vorkommens der Elementmenge (X) angibt.
- in Verbindung mit der Schleifenanweisung ein Steuerungsablauf, der für die Komponente erzeugt wird, und eine Anweisung zur Einfügung eines neuen Anwesenheitscodes ("flagX) auf einem Bit eines neuen Vorkommens der Elementmenge (X) im Dokument.

**15.** Verfahren zur Kompression nach einem der Ansprüche 1 bis 14, **dadurch gekennzeichnet, dass** jede Komponente des Strukturschemas (1) einer Elementmenge entspricht, die mindestens ein Informationselement umfasst, **dadurch**, dass das Strukturschema (1) des strukturierten Dokumentes (2) mindestens eine Komponente der Art geordnete Komponentensequenz umfasst, deren Erscheinungsreihenfolge in der Sequenz die Erscheinungsreihenfolge im Dokument der Elementmenge definiert, die den Komponenten der Gruppe der Art Sequenz entspricht, und **dadurch**, dass die Sequenz der Anweisungen, die für eine Sequenz mit n Komponenten (X1, X2, ...., Xn) erzeugt wird, aufeinander folgend Anweisungssequenzen umfasst, die für jede Komponente der Sequenz erzeugt werden.

**16.** Verfahren zur Kompression nach einem der Ansprüche 1 bis 15, **dadurch gekennzeichnet, dass** jede Komponente des Strukturschemas (1) einer Elementmenge entspricht, die mindestens ein Informationselement umfasst, **dadurch**, dass das Strukturschema (1) des zu komprimierenden Dokumentes (2) mindestens eine Komponente der Art alternative Komponentengruppe umfasst, wobei jede alternative Komponente einer Gruppe von Informationselementen entspricht, wobei die Komponente der Art alternative Komponentengruppe im Dokument einer der Informationsgruppen entspricht, die den alternativen Komponenten entsprechen, und **dadurch**, dass die Sequenz von Anweisungen, die für eine Gruppe von alternativen Komponenten erzeugt wird, n Komponenten umfasst, die jeweils n Elementmengen definiert (X1, X2, ...., Xn), nacheinander umfasst:

- eine Anweisung zur Einfügung eines Nummerncodes der Elementmenge ("flagChox), der die Elementmenge bezeichnet, die im Dokument (2) unter den n Elementmengen (X1, X2, ...., Xn) erscheint, verbunden mit der Größe durch die Bit-Anzahl dieses Codes, und
- Anweisungen zum Test des Wertes des Nummerncodes der Elementmenge, wobei jede Anweisung zum Test mit einer Anweisungssequenz verbunden ist, die für die Komponente erzeugt wird, die der Elementmenge (Xi) entspricht, die dem getesteten Wert des Nummerncodes Elementgruppe entspricht.

**17.** Verfahren zur Kompression nach einem der Ansprüche 1 bis 16, **dadurch gekennzeichnet, dass** jede Komponente des Strukturschemas (1) einer Gruppe von Elementen entspricht, die mindestens ein Informationselement umfasst, **dadurch**, dass das Strukturschema (1) des zu komprimierenden Dokumentes mindestens eine Gruppe der Art nicht geordnete Komponenten umfasst, wobei jede Komponente der nicht geordneten Gruppe einer Elementmenge entspricht und die Gruppe der Art nicht geordnete Gruppe im Dokument einer Gruppe entspricht, die in einer beliebigen Reihenfolge alle Elementmengen versammelt, die den Komponenten der Gruppe der nicht geordneten Art entsprechen, und **dadurch**, dass der Steuerungsablauf, der für eine Gruppe der nicht geordneten Art mit n Komponenten erzeugt wird, im entsprechenden Dokument n Elementmengen entspricht (X1, X2, .... , Xn) nacheinander umfasst:

- eine Anweisung zur Einfügung eines Codes ("flagChoX") der Anzahl der Elementmengen (Xi) und Bezeichnung der folgenden Elementmenge, die im Dokument (2) erscheint, verbunden mit der Größe durch die Bit-Anzahl dieses Codes, und
- Anweisungen zum Test des Wertes des Nummerncodes der Elementmenge, wobei jede Anweisung zum Test mit einer Anweisungssequenz verbunden ist, die für die Komponente erzeugt wird, die der Elementmenge (Xi) erzeugt wird, die dem Wert des Nummerncodes der getesteten Elementmenge entspricht, und eine Anweisungssequenz, die für eine Gruppe der nicht geordneten Art mit allen Komponenten (X1, ...., Nn) der nicht geordneten Gruppe außer der Komponente, die der Gruppe von Elementen entspricht (Xi), erzeugt wird.

**18.** Verfahren zur Dekompression eines strukturierten Dokumentes, umfassend Informationselemente, die ineinander verschachtelte und jeweils mit einer Informationsart verbunden sind, wobei das strukturierte Dokument (2) mit mindestens einem Strukturschema (1; 31, 39, 43) verbunden ist, das eine Baumstruktur des Dokumentes definiert und ineinander verschachtelte Strukturkomponenten (a3, a4, X, Y, a1, a5, a1, a2, A, B, 32, 33, 34, 40, 44, 45, 46) umfasst, wobei jede Informationsart des Dokumentes durch eine Komponente des Schemas definiert ist, **dadurch gekennzeichnet, dass** es Schritte aufweist, die Folgendes umfassen:

- Analysieren (11) des Strukturschemas (1) des Dokumentes, Erzeugen für jede Komponente des Strukturschemas eine ausführbarer Steuerungsablaufs (5) mit Leseanweisungen in einen binären Fluss, der das komprimierte Dokument (10) darstellt, Kontrollcodes und komprimierte Werte von Informationselementen oder Aufrufcodes von Steuerungsabläufen der Komponente und Kontrollanweisungen des Ablaufs der Durchführung der Sequenz je nach den Werten des Kontrollcodes, die Durchführung der Steuerungsabläufe auf dem komprimierten Dokument (10), die es ermöglicht, ein Dokument (2') im Format des ursprünglichen Dokumentes (2) und mit einer mindestens gleichwertigen Struktur wiederherzustellen,
- Durchführen (14) der erzeugten Steuerungsabläufe auf dem binären Fluss, der das erzeugte wiederherzustellende Dokument (2') darstellt, um ein strukturiertes Dokument (2') im Format des ursprünglichen strukturierten Dokumentes (2) und mit einer mindestens gleichwertigen Struktur zu erhalten.

**19.** Verfahren zur Dekompression nach Anspruch 18, **dadurch gekennzeichnet, dass**, da das strukturierte Dokument (2) nicht in Unterelemente zerlegte Grundelemente umfasst, mindestens eine Informationsart der Grundelemente mit einem Dekompressionsalgorithmus (16') verbunden ist, der der Informationsart angepasst ist, wobei das Verfahren während der Durchführung der Steuerungsabläufe (5) auf dem binären Fluss, der das komprimierte Dokument (10) darstellt, die Feststellung im binären Fluss eines binären Codes von Informationselementen umfasst, die der Informationsart entsprechen, sowie die Anwendung des Dekompressionsalgorythmus auf diesen binären Code.

**20.** Verfahren zur Dekompression nach Anspruch 18 oder 19, **dadurch gekennzeichnet, dass** es einen Schritt des Kompilierens (17) der Steuerungsabläufe (5) umfasst, die für jede Komponente des Strukturschemas (5) erhalten werden, um ein binäres Decodierungsprogramm (6) zu erhalten, das dem Strukturschema zugewiesen und direkt von einem Rechner durchführ- oder interpretierbar ist, um ein Dokument (10) mit diesem Strukturschema (1) zu dekomprimieren.

**21.** Verfahren zur Dekompression nach einem der Ansprüche 18 bis 20, **dadurch gekennzeichnet, dass** es einen vorherigen Schritt des Normalisierens (12) des Strukturschemas (5) des Dokumentes umfasst, um eine einmalige vordefinierte Reihenfolge der Komponenten des Schemas zu erhalten.

**22.** Verfahren zur Dekompression nach einem der Ansprüche 18 bis 21, **dadurch gekennzeichnet, dass** es einen vorherigen Schritt (12) des Optimierens und des Vereinfachens des Strukturschemas (5) des Dokumentes umfasst, der darin besteht, die Anzahl der hierarchischen Niveaus der Strukturkomponentengruppen zu reduzieren.

**23.** Verfahren zur Dekompression nach einem der Ansprüche 18 bis 22, **dadurch gekennzeichnet, dass** mindestens ein Informationselementcode des Dokumentes im binären Fluss des komprimierten Dokumentes so markiert ist, dass er den direkten Zugang zu diesem Informationselement ermöglicht, ohne dass es erforderlich ist, die Informationselemente zu dekomprimieren, die diesem Element im binären Fluss vorausgehen.

24. Verfahren zur Dekompression nach einem der Ansprüche 18 bis 23, **dadurch gekennzeichnet, dass** das komprimierte Dokument (10) für jedes Informationselement des originalen Dokumentes einen Code umfasst, der es ermöglicht, die Art der mit dem Informationselement verbundenen Information sowie den binären Wert des komprimierten Informationselementes zu bestimmen.

25. Verfahren zur Dekompression nach einem der Ansprüche 18 bis 24, **dadurch gekennzeichnet, dass** das Strukturschema (1) des zu dekomprimierenden Dokumentes (10) die Definition von Unterarten mindestens einer Informationsart (TX) umfasst, und **dadurch**, das der Steuerungsablauf (5), der für eine Komponente einer Art (TX) mit n Unterarten ($S_1$, $S_2$, ..., $S_n$) erzeugt wird, nacheinander umfasst:

> - eine Leseanweisung eines Unterartcodes ("flagPoly"), der eine Nummer einer Unterart darstellt, die auf ein Element (X) anzuwendenden ist, das im Dokument der Komponente entspricht, verbunden mit der Größe dieses Codes durch die Bit-Anzahl, und
> - Anweisungen zum Test des Codewertes der Unterart, wobei jede Testanweisung mit einer Referenz auf die Unterart ($S_1$, $S_2$, ..., $S_n$) des Elementes (X) verbunden ist, das dem Codewert der getesteten Unterart entspricht, sowie mit einem Steuerungsablauf, der für die Kompression eines mit der Unterart verbundenen Elementes (X) erzeugt wird.

26. Verfahren zur Dekompression nach einem der Ansprüche 18 bis 25, **dadurch gekennzeichnet, dass** im binären Fluss des komprimierten Dokumentes (10) das Ende einer Gruppe des mehrfachen Vorkommens einer Elementmenge mit mindestens einem Informationselement und einer Komponente des Schemas (1) entsprechend durch einen bestimmten binären Code markiert ist.

27. Verfahren zur Dekompression nach einem der Ansprüche 18 bis 26, **dadurch gekennzeichnet, dass** jede Komponente des Strukturschemas (1) im binären Fluss des Dokumentes (10) einer Elementmenge entspricht, die mindestens ein Informationselement umfasst, und außerdem mit einer Gesamtanzahl möglicher Vorkommen verbunden ist, wobei die Häufigkeit angegeben wird, mit der eine Elementmenge, die dieser Strukturkomponente entspricht, im Informationselement der Ebene erscheinen kann, die unmittelbar über derjenigen liegt, zu der sie gehört.

28. Verfahren zur Dekompression nach Anspruch 27, **dadurch gekennzeichnet, dass** der Steuerungsablauf, der für eine Komponente mit einer Anzahl des Vorkommens gleich 0 oder 1 erzeugt wird, nacheinander umfasst:

> - eine Leseanweisung eines Anwesenheitscodes ("flagX") auf einem Bit, der die An- oder die Abwesenheit einer Elementmenge (X), die der Komponente entspricht, im komprimierten Dokument (2) angibt.
> - eine Anweisung zum Test des Wertes des Anwesenheitscodes und
> - in Verbindung mit der Testanweisung, wenn der Wert des Anwesenheitscodes die Anwesenheit der Elementmenge (X) im komprimierten Dokument angibt, ein Steuerungsablauf, der für die Komponente unabhängig von der Anzahl der verbundenen Vorkommnisse erzeugt wird.

29. Verfahren zur Dekompression nach Anspruch 21 oder 28, **dadurch gekennzeichnet, dass** der Steuerungsablauf, der für eine Komponente mit einer Anzahl des Vorkommens zwischen n und m erzeugt wird, nacheinander umfasst:

> - eine Leseanweisung eines Codes der Anzahl des Vorkommens ("loopflagX"), der die Anzahl des aufeinander folgenden Vorkommens im komprimierten Dokument einer Elementmenge (X) angibt, die der Komponente entspricht, von der die die Anzahl n des minimalen Vorkommens abgezogen wurde, verbunden mit der Größe dieses Codes durch die Bit-Anzahl.
> - eine Schleifenanweisung, die die Anzahl der Widerholungen definiert, die dem Wert des Codes der Anzahl des Vorkommens entspricht und
> - in Verbindung mit der Schleifenanweisung ein Steuerungsablauf, der für die Komponente unabhängig von der Anzahl der verbundenen Vorkommnisse erzeugt wird.

30. Verfahren zur Dekompression nach Anspruch 29, **dadurch gekennzeichnet, dass** der Steuerungsablauf, der für eine Komponente mit einer Anzahl des Vorkommens zwischen 0 und m erzeugt wird, außerdem aufweist:

- eine Leseanweisung eines Anwesenheitscodes ("shuntflagX"), der auf einem Bit die An- oder Abwesenheit im komprimierten Dokument mindestens eines Vorkommens einer Elementmenge (X) entsprechend der Komponente angibt, und
- eine Anweisung zum Test des Wertes des Anwesenheitscode, verbunden mit dem Steuerungsablauf, der für eine Anzahl des Vorkommens zwischen 1 und m der Komponente erzeugt wurde, wenn der Wert des Anwesenheitscodes die Anwesenheit von mindestens einer Elementmenge angibt.

**31.** Verfahren zur Dekompression nach Anspruch 27, **dadurch gekennzeichnet, dass** der Steuerungsablauf, der für eine Komponente mit einer Anzahl des Vorkommens zwischen n und m erzeugt wird, nacheinander umfasst:

- eine Leseanweisung eines Anwesenheitscodes("flagX") auf einem Bit eines Vorkommens einer Elementmenge (X), der der Komponente im komprimierten Dokument (2) entspricht, verbunden mit der Größe dieses Codes durch die Bit-Anzahl.
- eine Schleifenanweisung, die durchgeführt werden muss, sobald die im binären Fluss des komprimierten Dokumentes gelesene Anwesenheitsschleife die Anwesenheit eines neuen Vorkommens der Elementmenge (X) angibt.
- in Verbindung mit der Schleifenanweisung ein Steuerungsablauf, der für die Komponente erzeugt wird, und eine Anweisung zur Einfügung eines neuen Anwesenheitscodes ("flagX) auf einem Bit einer neuen Anwesenheit der Elementmenge (X) im komprimierten Dokument (10).

**32.** Verfahren zur Dekompression nach einem der Ansprüche 18 bis 31, **dadurch gekennzeichnet, dass** jede Komponente des Strukturschemas (1) einer Elementmenge entspricht, die mindestens ein Informationselement umfasst, **dadurch**, dass das Strukturschema (1) des komprimierten Dokumentes (10) mindestens eine Komponente der Art geordnete Komponentensequenz umfasst, deren Erscheinungsreihenfolge in der Sequenz die Erscheinungsreihenfolge im Dokument der Elementmenge definiert, die den Komponenten der Gruppe der Art Sequenz entspricht, und **dadurch**, dass die Sequenz der Anweisungen, die für eine Sequenz mit n Komponenten (X1, X2, ...., Xn) erzeugt wird, aufeinander folgend Anweisungssequenzen umfasst, die für jede Komponente der Sequenz erzeugt werden.

**33.** Verfahren zur Dekompression nach einem der Ansprüche 18 bis 32, **dadurch gekennzeichnet, dass** jede Komponente des Strukturschemas (1) einer Gruppe von Elementen entspricht, die mindestens ein Informationselement umfasst, **dadurch**, dass das Strukturschema (1) des zu komprimierenden Dokumentes (2) mindestens eine Komponente der Art alternative Komponentengruppe umfasst, wobei jede alternative Komponente einer Menge von Informationselementen entspricht, wobei die Komponente der Art alternative Komponentengruppe im Dokument einer der Informationsmengen entspricht, die den alternativen Komponenten entsprechen, und **dadurch**, dass die Sequenz von Anweisungen, die für eine Gruppe von alternativen Komponenten erzeugt wird, n Komponenten umfasst, die jeweils n Elementmengen definieren (X1, X2, ...., Xn), nacheinander umfasst :

- eine Leseanweisung eines Nummerncodes der Elementmenge ("flagChoX), die alle Elemente bezeichnet, die im Dokument (10) unter den n Elementmengen (X1, X2, ..., Xn) erscheinen, verbunden mit der Größe durch die Bit-Anzahl dieses Codes, und
- Anweisungen zum Test des Wertes des Nummerncodes der Elementmenge, wobei jede Anweisung zum Test mit einer Anweisungssequenz verbunden ist, die für die Komponente erzeugt wird, die der Elementmenge (Xi) entspricht, die dem getesteten Wert des Nummerncodes der Elementmenge entspricht

**34.** Verfahren zur Dekompression nach einem der Ansprüche 18 bis 33, **dadurch gekennzeichnet, dass** jede Komponente des Strukturschemas (1) einer Elementmenge entspricht, die mindestens ein Informationselement umfasst, **dadurch**, dass das Strukturschema (1) des zu dekomprimierenden Dokumentes mindestens eine Gruppe der Art nicht geordnete Komponenten umfasst, wobei jede Komponente der nicht geordneten Gruppe einer Elementmenge entspricht und die Gruppe der Art nicht geordnete Gruppe im Dokument einer Gruppe entspricht, die in einer beliebigen Reihenfolge alle Elementmengen versammelt, die den Komponenten der Gruppe der nicht geordneten Art entsprechen, und **dadurch**, dass der Steuerungsablauf, der für eine Gruppe der nicht geordneten Art mit n Komponenten erzeugt wird, im entsprechenden Dokument n Elementmengen entspricht (X1, X2, ...., Xn) nacheinander umfasst :

- eine Leseanweisung eines Nummerncodes der Elementmenge (Xi) und Bezeichnung der folgenden Elementmenge, die im Dokument (10) erscheint, verbunden mit der Größe durch die Bit-Anzahl dieses Codes, und
- Anweisungen zum Test des Wertes des Nummerncodes der Elementmenge, wobei jede Anweisung zum Test mit einem Steuerungsablauf verbunden ist, der für die Komponente erzeugt wird, die der Elementmenge (Xi) entspricht, die dem Wert des Nummerncodes der getesteten Elementmenge entspricht, und ein Steuerungsablauf, der für eine Gruppe der nicht geordneten Art erzeugt wird, umfassend alle Komponenten (X1, ...., Nn) der nicht geordneten Gruppe außer der Komponente, die der Elementmenge entspricht (Xi).

FIG. 1

FIG. 3

## FIG. 2a

```
                    ┌──────┐
                    │  TA  │
                    └──────┘──31
                       │
                 ┌──────────┐
                 │ SEQ[1,1] │──32
                 └──────────┘
              ┌──────┴───────┐
        ┌─────────┐     ┌──────────┐
        │ ET[1,1] │     │ SEQ[1,1] │──34
        └─────────┘──33 └──────────┘
        ┌────┴────┐       ┌────┴────┐
   ┌──────────┐┌──────────┐┌─────────┐┌─────────┐
   │a3int[1,1]││a4int[0,1]││XTC[1,1] ││YTC[1,1] │
   └──────────┘└──────────┘└─────────┘└─────────┘
```

## FIG. 2b

```
              ┌──────┐
              │  TB  │
              └──────┘──39
                 │
           ┌──────────┐
           │ SEQ[1,1] │──40
           └──────────┘
        ┌──────┴──────┐
 ┌──────────────┐┌──────────────┐
 │ a1bool[1,1]  ││ a5bool[1,1]  │
 └──────────────┘└──────────────┘
```

## FIG. 2c

```
                   ┌──────┐
                   │  TC  │
                   └──────┘──43
                      │
                ┌──────────┐
                │ SEQ[1,1] │──44
                └──────────┘
            ┌────────┴─────────┐
      ┌────────────┐      ┌──────────┐
      │ ETNo[1,1]  │      │ CHO[1,1] │──46
      └────────────┘──45  └──────────┘
        ┌────┴─────┐        ┌────┴────┐
 ┌──────────┐┌───────────┐┌─────────┐┌─────────┐
 │a1int[1,1]││a2bool[1,1]││ATA[1,1] ││BTB[1,1] │
 └──────────┘└───────────┘└─────────┘└─────────┘
```

## FIG. 4a

```
             ┌──────┐
             │  TA  │
             └──────┘──31'
                │
          ┌──────────┐
          │ CHO[1,*] │──53
          └──────────┘
    ┌───────┬────┴────┬───────┐
┌─────────┐┌─────────┐┌─────────┐┌─────────┐
│a3int[1,1]││a4int[0,1]││XTC[1,1]││YTC[1,1]│
└─────────┘└─────────┘└─────────┘└─────────┘
```

## FIG. 4b

```
             ┌──────┐
             │  TB  │
             └──────┘──39'
                │
          ┌──────────┐
          │ CHO[1,*] │──55
          └──────────┘
        ┌─────┴──────┐
 ┌────────────┐┌────────────┐
 │ a1bool[1,1]││ a5bool[1,1]│
 └────────────┘└────────────┘
      │              │
      41             42
```

## FIG. 4c

```
             ┌──────┐
             │  TC  │
             └──────┘──43'
                │
          ┌──────────┐
          │ CHO[1,*] │──54
          └──────────┘
    ┌───────┬────┴────┬───────┐
┌──────────┐┌───────────┐┌─────────┐┌─────────┐
│a1int[1,1]││a2bool[1,1]││ATA[1,1] ││BTB[1,1] │
└──────────┘└───────────┘└─────────┘└─────────┘
```